(19) **Europäisches Patentamt / European Patent Office / Office européen des brevets**

(11) **EP 4 782 867 A1**

(12) # EUROPEAN PATENT APPLICATION

(43) Date of publication:
**29.07.2026   Bulletin 2026/31**

(21) Application number: **26154850.7**

(22) Date of filing: **28.01.2026**

(51) International Patent Classification (IPC):
**G01R 33/48** (2006.01)      **G01R 33/56** (2006.01)
**G01R 33/561** (2006.01)      **G01R 33/565** (2006.01)

(52) Cooperative Patent Classification (CPC):
**G01R 33/5608; G01R 33/4818; G01R 33/561; G01R 33/56545**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority:   **28.01.2025   JP 2025012495**

(71) Applicant: **FUJIFILM Corporation**
**Tokyo 106-8620 (JP)**

(72) Inventors:
• **SUZUKI, Atsuro**
**Tokyo, 106-8620 (JP)**

• **SHIRAI, Toru**
**Tokyo, 106-8620 (JP)**
• **YOKOSAWA, Suguru**
**Tokyo, 106-8620 (JP)**
• **SHOJI, Hiroki**
**Tokyo, 106-8620 (JP)**
• **HIRAKAWA, Yuya**
**Tokyo, 106-8620 (JP)**

(74) Representative: **Dehns Germany Partnerschaft mbB**
**Theresienstraße 6-8**
**80333 München (DE)**

(54) **MAGNETIC RESONANCE IMAGING APPARATUS, IMAGE PROCESSING APPARATUS, IMAGE PROCESSING METHOD, AND PROGRAM**

(57)      An apparatus (10) for magnetic resonance imaging is disclosed. The apparatus (10) estimates, using a projection onto convex sets method, data of an unmeasured region from partial measurement data that is data acquired within an asymmetrical measurement region (MA) of a k-space, and includes a processor (202) configured to: input a partial measurement image reconstructed based on the partial measurement data to a trained model; estimate an image reconstructed from full measurement data corresponding to the partial measurement data from the partial measurement image using the trained model to generate an estimation image; generate a phase image indicating a phase distribution from the estimation image; and apply the phase image to phase correction in the projection onto convex sets method.

FIG. 12

## Description

## BACKGROUND OF THE INVENTION

1. Field of the Invention

The present disclosure relates to a magnetic resonance imaging apparatus, an image processing apparatus, an image processing method, and a program, and particularly relates to a signal processing technique for generating a reconstruction image from partial k-space data collected from an asymmetrical region in a k-space.

2. Description of the Related Art

In magnetic resonance imaging (MRI) imaging using an MRI apparatus, in order to reduce an imaging time, a half-Fourier method is used in which a k-space corresponding to a matrix size of a field of view (FOV) is partially asymmetrically measured, and data of an unmeasured region is estimated based on data of measured values acquired from a measurement region. The half-Fourier method is a method of estimating data of an unmeasured region from data of a measurement region by using Hermitian conjugate of the k-space to generate a reconstruction image. In this method, as the unmeasured region in the k-space increases, the degradation of image quality of the reconstruction image increases.

In order to solve such an issue, in US2022/0198725A, image quality of an image generated from partial measurement data is improved by using a convolutional neural network (CNN) trained through machine learning using, as training data, a pair of a reconstruction image of full measurement data collected by measuring an entire region of a matrix of the k-space and a reconstruction image of partial measurement data collected in an asymmetrical measurement region set in the k-space.

## SUMMARY OF THE INVENTION

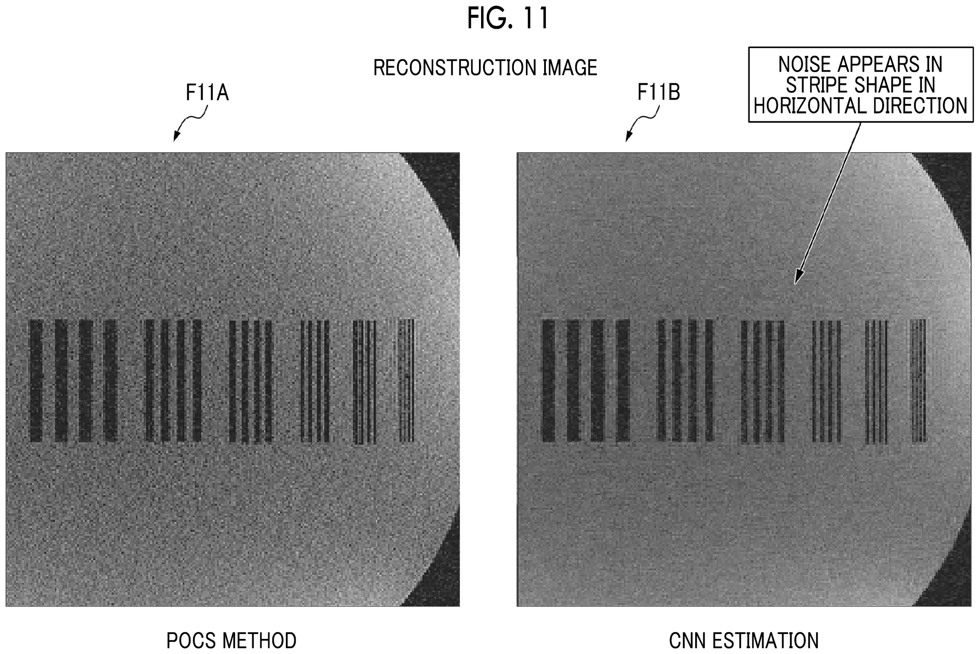

In the method using the CNN described in US2022/0198725A, since the noise of the unmeasured region in the k-space is not estimated, the reconstruction image having a high signal-to-noise ratio (SNR) is obtained. On the other hand, due to the asymmetry of the signal intensity of the noise caused by not estimating the noise of the unmeasured region, the noise is visually recognized in a stripe shape in the reconstruction image. A specific example of the striped noise will be described later with reference to FIG. 11.

The present disclosure has been made in view of such circumstances, and an object of the present disclosure is to provide a magnetic resonance imaging apparatus, an image processing apparatus, an image processing method, and a program that can suppress the occurrence of striped noise in an image reconstructed based on partial k-space data acquired within an asymmetrical measurement region of the k-space and generate a high-quality image.

A first aspect of the present disclosure relates to a magnetic resonance imaging apparatus comprising: a processor configured to execute processing of estimating, using a projection onto convex sets method, data of an unmeasured region from partial measurement data that is data acquired within an asymmetrical measurement region of a k-space, in which the processor is configured to: input a partial measurement image reconstructed based on the partial measurement data to a trained model; estimate an image reconstructed from full measurement data corresponding to the partial measurement data from the partial measurement image using the trained model to generate an estimation image; generate a phase image indicating a phase distribution from the estimation image; and apply the phase image to phase correction in the projection onto convex sets method.

According to the first aspect, the data of the unmeasured region is estimated including noise by repeatedly executing correction using the phase image by an algorithm of the projection onto convex sets (POCS) method. Therefore, the magnetic resonance imaging apparatus according to the first aspect can improve performance of estimating the data of the unmeasured region and suppress the occurrence of the striped noise in the reconstruction image, as compared with the method using the CNN described in US2022/0198725A. In addition, according to the first aspect, since a high-accuracy phase image estimated from the partial measurement image is used in the POCS method using the trained model generated by learning (training on) a relationship between the partial measurement image and the image reconstructed from the full measurement data through machine learning, the artifacts can be reduced while reducing the occurrence of the striped noise.

The measurement data obtained by measuring a nuclear magnetic resonance signal of a subject using the magnetic resonance imaging apparatus is complex data, and the partial measurement image reconstructed from the partial measurement data and the estimation image estimated based on the partial measurement image are each a complex image. In this specification, the term "image" in terms such as the partial measurement image, the estimation image, and the phase image includes a concept of image data.

A first embodiment relates to the magnetic resonance imaging apparatus according to the first aspect, in which the processor may be configured to generate the partial measurement image from k-space data including the partial measurement data complemented by filling the unmeasured region with zero data.

A second embodiment relates to the magnetic resonance imaging apparatus according to the first aspect or first embodiment, in which the processor may be configured to generate the phase image by performing processing of smoothing the estimation image.

A third embodiment relates to the magnetic resonance imaging apparatus according to the second embodiment, in which the processor may be configured to perform the processing of smoothing the estimation image using a filter.

A fourth embodiment relates to the magnetic resonance imaging apparatus according to the third embodiment, in which the processor may be configured to variably set strength of the filter.

A fifth embodiment relates to the magnetic resonance imaging apparatus according to the third or fourth embodiment, in which the processor may be configured to receive information for setting the strength of the filter via a user interface, and set the strength of the filter in accordance with the received information.

A sixth embodiment relates to the magnetic resonance imaging apparatus according to any one of the third to fifth embodiments, in which the processor may be configured to calculate a signal-to-noise ratio of an image generated using the projection onto convex sets method based on the partial measurement data, and set the strength of the filter in accordance with the signal-to-noise ratio.

A seventh embodiment relates to the magnetic resonance imaging apparatus according to any one of the third to sixth embodiments, in which the processor may be configured to set the strength of the filter in accordance with an unmeasured proportion of the partial measurement data.

An eighth embodiment relates to the magnetic resonance imaging apparatus according to any one of the third to seventh embodiments, in which the processor may be configured to set the strength of the filter in accordance with a pulse sequence by which the partial measurement data is obtained.

A ninth embodiment relates to the magnetic resonance imaging apparatus according to the first aspect or any one of the first to eight embodiments, in which the processor may be configured to perform filter processing in which at least one of an edge enhancement filter or a smoothing filter is applied, on a corrected image subjected to the phase correction.

A tenth embodiment relates to the magnetic resonance imaging apparatus according to the first aspect or any one of the first to ninth embodiments, in which an algorithm of the projection onto convex sets method executed by the processor may include: processing of generating k-space data including the partial measurement data by filling the unmeasured region of the partial measurement data with zero data or estimation data; processing of generating an absolute value image by performing processing of image reconstruction including an inverse Fourier transform and processing of absolute value image generation on the k-space data; processing of performing the phase correction by applying the phase image to the absolute value image; and processing of updating the k-space data by replacing data corresponding to the measurement region in estimated k-space data generated by a Fourier transform based on the corrected image obtained by the phase correction with the partial measurement data that has been measured or data corresponding to the measurement region in k-space data generated by a Fourier transform based on the estimation image, and the data of the unmeasured region may be estimated by performing iterative processing including generation of the absolute value image, the phase correction, and update of the k-space data.

An eleventh embodiment relates to the magnetic resonance imaging apparatus according to the first aspect or any one of the first to tenth embodiments, in which the trained model may include a convolutional neural network.

A twelfth embodiment relates to the magnetic resonance imaging apparatus according to the first aspect or any one of the first to eleventh embodiments, in which the trained model may include a machine learning model trained through machine learning to receive an input of the partial measurement image and output the estimation image in which a reconstruction image of the full measurement data is estimated.

A thirteenth embodiment relates to the magnetic resonance imaging apparatus according to the first aspect or any one of the first to eleventh embodiments, in which the trained model may include a machine learning model trained through machine learning to receive an input of the partial measurement image and output a residual image indicating a difference between the estimation image and the partial measurement image.

A fourteenth embodiment relates to the magnetic resonance imaging apparatus according to the first aspect or first to thirteenth embodiments, in which the trained model may include a machine learning model generated by performing machine learning using a training dataset including a pair of a first full measurement image reconstructed based on first k-space data in which an entire region of a data acquisition matrix of a k-space is filled with measured data and a first partial measurement image reconstructed based on second k-space data in which an asymmetrical first region of a portion of the data acquisition matrix is filled with measurement data corresponding to the first k-space data and a second region other than the first region is filled with zero data, the first full measurement image being ground-truth data for an input of the first partial measurement image.

A fifteenth embodiment relates to the magnetic resonance imaging apparatus according to the fourteenth embodiment, in which the second k-space data may be generated by replacing data of the second region in the first k-space data with zero data.

A sixteenth embodiment relates to the magnetic resonance imaging apparatus according to the first aspect or any one of the first to fifteenth embodiments, in which the processor may be configured to: acquire first measurement region data of the measurement region in k-space data obtained by performing a Fourier transform on the estimation image; generate a first edge enhancement estimation image by performing edge enhancement filter processing on the estimation image; acquire first unmeasured region data of the unmeasured region in k-space data obtained by performing a Fourier transform on the first edge enhancement estimation image; reconstruct an image based on k-space data including the first measurement region data and the first unmeasured region data to generate a second edge enhancement estimation image; and generate the phase image from the second edge enhancement estimation image.

A seventeenth embodiment relates to the magnetic resonance imaging apparatus according to the sixteenth embodiment, in which the processor may be configured to: acquire first adjacent region data corresponding to an adjacent region that is adjacent to the measurement region and that extends a predetermined distance from the measurement region, in second unmeasured region data of the unmeasured region in the k-space data obtained by performing a Fourier transform on the estimation image; acquire second adjacent region data corresponding to the adjacent region in the first unmeasured region data; generate third adjacent region data by combining the first adjacent region data and the second adjacent region data while gradually decreasing a weight of the first adjacent region data and gradually increasing a weight of the second adjacent region data as a distance from the measurement region increases; and generate the second edge enhancement estimation image by reconstructing an image from k-space data including the first measurement region data, the third adjacent region data, and the first unmeasured region data other than the adjacent region.

An eighteenth embodiment relates to the magnetic resonance imaging apparatus according to the seventeenth embodiment, in which the processor may be configured to: multiply the first adjacent region data by a first window function having a value of 1 at a position adjacent to the measurement region and a value of 0 at a position at the predetermined distance from the measurement region; multiply the second adjacent region data by a second window function having a value of 0 at a position adjacent to the measurement region and a value of 1 at a position at the predetermined distance from the measurement region; and generate the third adjacent region data by adding the first adjacent region data multiplied by the first window function and the second adjacent region data multiplied by the second window function.

A nineteenth embodiment relates to the magnetic resonance imaging apparatus according to the eighteenth embodiment, in which the first window function and the second window function may be each a Hanning window.

A twentieth embodiment relates to the magnetic resonance imaging apparatus according to any one of the sixteenth to nineteenth embodiments, in which the processor may be configured to: acquire filter strength of the edge enhancement filter processing; and generate the first edge enhancement estimation image on which the edge enhancement filter processing is performed with the acquired filter strength.

A twenty-first embodiment relates to the magnetic resonance imaging apparatus according to the twentieth embodiment, in which the processor may be configured to acquire the filter strength of the edge enhancement filter processing based on an average value of absolute values of the first measurement region data and an average value of absolute values of the first unmeasured region data.

A twenty-second embodiment relates to the magnetic resonance imaging apparatus according to the twentieth or twenty-first embodiment, in which the processor may be configured to receive a setting of the filter strength of the edge enhancement filter processing via a user interface.

A twenty-third embodiment of the present disclosure relates to an image processing apparatus comprising: a processor; and a storage device including a memory, in which the storage device stores a trained model, and the processor is configured to: acquire partial measurement data that is data acquired within an asymmetrical measurement region of a k-space; input a partial measurement image reconstructed based on the partial measurement data to the trained model; estimate an image reconstructed from full measurement data corresponding to the partial measurement data from the partial measurement image using the trained model to generate an estimation image; generate a phase image indicating a phase distribution from the estimation image; apply the phase image to phase correction in the projection onto convex sets method; and execute processing of estimating data of an unmeasured region other than the measurement region in the k-space using the projection onto convex sets method.

The image processing apparatus according to the twenty-third embodiment may have the same embodiment as the magnetic resonance imaging apparatus according to any one of the first to twenty-second embodiments.

A second aspect of the present disclosure relates to an image processing method executed by a processor, the image processing method comprising: acquiring partial measurement data that is data acquired within an asymmetrical measurement region of a k-space; inputting a partial measurement image reconstructed based on the partial measurement data to a trained model; estimating an image reconstructed from full measurement data corresponding to the partial measurement data from the partial measurement image using the trained model to generate an estimation image; generating a phase image indicating a phase distribution from the estimation image; applying the phase image to phase correction in the projection onto convex sets method; and executing processing of estimating data of an unmeasured region other than the measurement region in the k-space using the projection onto convex sets method.

The image processing method according to the second aspect may have the same specific embodiment as the magnetic resonance imaging apparatus according to any one of the first to twenty-second embodiments. The image processing method according to the second aspect may be a computer-implemented method.

A twenty-fourth embodiment of the present disclosure relates to a program for causing a computer to execute the image processing method according to the second aspect. The program according to the twenty-fourth embodiment may have the same specific embodiment as the magnetic resonance imaging apparatus according to any one of the first to twenty-first embodiments. A third aspect of the present disclosure encompasses a tangible, non-transitory computer-readable storage medium on which the program according to the twenty-fourth embodiment is stored.

According to the present disclosure, it is possible to suppress the occurrence of the striped noise in the image reconstructed based on the partial measurement data, which is the partial k-space data acquired within the asymmetrical measurement region of the k-space, and generate the high-quality image.

## BRIEF DESCRIPTION OF THE DRAWINGS

FIG. 1 is a diagram illustrating a schematic configuration of an MRI apparatus according to an embodiment of the present disclosure.

FIG. 2 is a diagram illustrating examples of full measurement data of a k-space and an MR image reconstructed from the full measurement data.

FIG. 3 is a diagram illustrating examples of each point of data disposed in the k-space and a k-trajectory.

FIG. 4 is a diagram illustrating an example of a data filling method using asymmetric k-space sampling.

FIG. 5 is a conceptual diagram illustrating a method of improving the degradation of image quality of the MR image using a CNN.

FIG. 6 is a diagram illustrating an example of a network structure of the CNN applied as a trained model.

FIG. 7 is a diagram illustrating examples of an input image and an output image of the CNN.

FIG. 8 is a diagram illustrating an example of a method of generating a training image set for training the CNN.

FIG. 9 is a diagram illustrating an example of a method of estimating data of an unmeasured region using a POCS method from partial measurement data that is data collected in an asymmetrical measurement region in the k-space.

FIG. 10 is a diagram illustrating examples of k-space data in which the unmeasured region is estimated by the POCS method from the partial measurement data and k-space data in which the unmeasured region is estimated by a CNN estimation method.

FIG. 11 is an example of a test phantom image reconstructed from each k-space data illustrated in FIG. 10.

FIG. 12 is a diagram illustrating an outline of an image processing method according to a first embodiment.

FIG. 13 is a block diagram illustrating a functional configuration of an image processing apparatus implemented in a control device.

FIG. 14 is a flowchart illustrating steps of the image processing method executed by the image processing apparatus according to the first embodiment.

FIG. 15 is a diagram illustrating an outline of a modification example of the image processing method illustrated in FIG. 12.

FIG. 16 is a block diagram illustrating a functional configuration for achieving a function of setting filter strength in the image processing apparatus.

FIG. 17 is a diagram illustrating an example of an effect of reducing the striped noise according to the first embodiment.

FIG. 18 is a diagram illustrating an MR image in a case in which the unmeasured region is estimated by the POCS method and an MR image in a case in which the unmeasured region is estimated by the CNN.

FIG. 19 is a diagram illustrating an outline of a method of improving resolution of a CNN estimation image in an image processing method according to a second embodiment.

FIG. 20 is a flowchart illustrating steps of the image processing method according to the second embodiment.

FIG. 21 is an example of an MR image showing improvement in the resolution.

FIG. 22 is a block diagram illustrating a functional configuration of a processor implemented in a control device of an MRI apparatus according to the second embodiment.

FIG. 23 is a diagram illustrating an outline of a method of smoothly connecting data of a measurement region and data of an estimation region to which edge enhancement is applied in an image processing method according to a third embodiment.

FIG. 24 is a graph illustrating a Hanning window function.

FIG. 25 is a flowchart illustrating steps of the image processing method according to the third embodiment.

## DESCRIPTION OF THE PREFERRED EMBODIMENTS

Hereinafter, preferred embodiments of the present invention will be described in detail with reference to the accompanying drawings. In this specification, the same components are denoted by the same reference numerals, and duplicate description thereof will be omitted as appropriate.

Configuration of Magnetic Resonance Imaging Apparatus

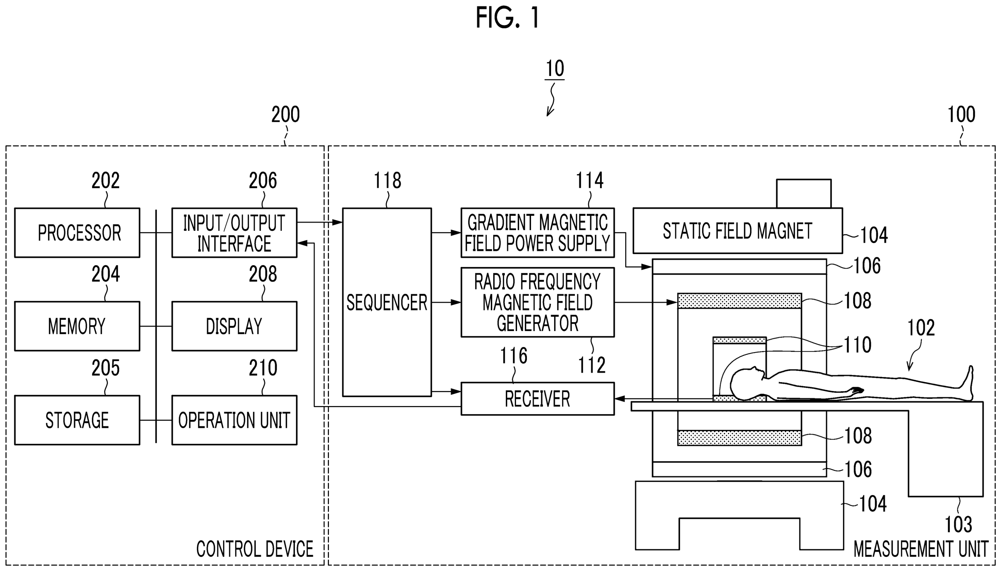

FIG. 1 is a diagram illustrating a schematic configuration of an MRI apparatus 10 according to the embodiment of the present disclosure. The MRI apparatus 10 comprises a measurement unit 100 and a control device 200. The measurement unit 100 comprises a static field magnet 104, a gradient coil 106, a radio frequency (RF) coil 108, a radio frequency magnetic field generator 112, a gradient magnetic field power supply 114, a receive coil 110, a receiver 116, and a sequencer 118.

The measurement unit 100 includes a gantry having a cylindrical imaging space called a bore, and elements such as the static field magnet 104, the gradient coil 106, and the RF coil 108 are disposed in the gantry. A subject 102 is usually placed in the imaging space in the gantry in a state of lying on a bed 103. The bed 103 may be fixed to the gantry or may be a movable dockable bed that is attachable to and detachable from the gantry.

The static field magnet 104 generates a uniform static magnetic field in the imaging space in which the subject 102 is placed. The static field magnet 104 includes a static magnetic field generation source of a permanent magnet type, a normal conduction type, or a superconducting type. The gradient coil 106 generates a gradient magnetic field in the imaging space. The RF coil 108 generates a radio frequency magnetic field that generates a nuclear magnetic resonance (NMR) signal in atomic nuclei of atoms constituting a tissue of the subject 102. The RF coil 108 is also referred to as a transmit coil. The receive coil 110 detects the NMR signal generated from the subject 102. The receive coil 110 is also referred to as an RF probe.

The sequencer 118 transmits control information to the radio frequency magnetic field generator 112 and the gradient magnetic field power supply 114 according to a pulse sequence (imaging sequence). The radio frequency magnetic field generator 112 generates radio frequency current pulses at the Larmor frequency that cause nuclear magnetic resonance based on the control information input from the sequencer 118, and transmits the radio frequency current pulse to the RF coil 108. The RF pulses corresponding to the radio frequency current pulses are transmitted from the RF coil 108 to the subject 102.

The receive coil 110 detects the NMR signal generated by exciting the nuclear spins in the subject 102 by the RF pulses, and transmits the detected NMR signal. The NMR signal is usually collected as a gradient echo or a spin echo, and is referred to as an echo signal herein.

The receive coil 110 illustrated in FIG. 1 is a coil that receives the echo signal from the head of the subject 102, but is not limited to the receive coil that receives the echo signal from the head, and a receive coil corresponding to an examination part of the subject 102 such as the chest, the abdomen, the waist, the shoulder, and the hand and foot may be used and set as appropriate. Further, there is also a flexible blanket type receive coil that is placed over the chest, the abdomen, and the waist.

The gradient coil 106 is composed of an X-axis gradient coil, a Y-axis gradient coil, and a Z-axis gradient coil that generate gradient magnetic fields Gx, Gy, and Gz in the X-axis direction, the Y-axis direction, and the Z-axis direction of the imaging space, respectively, and generates the gradient magnetic field corresponding to the current supplied from the gradient magnetic field power supply 114 in the imaging space. In the imaging space, an orthogonal tri-axial coordinate system is usually defined such that a direction of a central axis of the gantry is a Z-axis direction, a vertical direction is a Y-axis direction, and a direction orthogonal to both the Z-axis and the Y-axis is an X-axis direction.

The Z-axis gradient coil generates the gradient magnetic field Gz for selecting a slice position and a slice width of a plane of the subject 102 orthogonal to the Z-axis direction. The X-axis gradient coil generates the gradient magnetic field Gx proportional to the position in the X-axis direction as a readout direction (frequency encoding direction) gradient magnetic field during a period in which the echo signal is generated. The Y-axis gradient coil generates the phase encoding direction gradient magnetic field Gy having different intensities for each repetition time (TR).

The sequencer 118 controls each unit to operate at timing and intensity that are programmed in advance. Among the programs, particularly, a program that describes the timing and the intensity of the RF pulse, the gradient magnetic fields Gx, Gy, and Gz, and the signal reception is called the pulse sequence.

Various pulse sequences are known depending on the purpose, and for example, a spin echo method and a gradient echo method are known, and various pulse sequences derived from these methods are known. In addition, there is echo planar imaging (EPI), which is one of the high-speed imaging methods. In EPI, there are single-shot EPI, in which, during excitation by a single RF pulse, the gradient magnetic field is repeatedly reversed to generate a plurality of gradient echoes and fill k-space (the spatial-frequency domain) with the data required for image reconstruction, and multi-shot EPI, in which k-space is filled with echo-train data obtained over a plurality of shots.

The NMR signal generated from the subject 102 is detected by the receive coil 110, amplified by a preamplifier (not shown) in the receive coil 110, and transmitted to the receiver 116.

The receiver 116 includes a quadrature detection circuit, an analog-to-digital (A/D) converter, and other signal processing circuits. In the receiver 116, the amplified NMR signal is subjected to the A/D conversion and required signal processing to generate data. The data generated in this manner is transmitted to the control device 200.

For example, the receiver 116 executes the detection and the A/D conversion of the echo signal detected by the receive coil 110, and transmits two streams of digital data of a real part and an imaginary part to the control device 200. The digital data is also referred to as reception signal data or measurement data.

The sequencer 118 transmits information on the nuclear magnetic resonance frequency (detection reference frequency) that is a reference for quadrature detection performed by the receiver 116, a timing of the A/D conversion (sampling timing in the frequency encoding direction), and the like, and controls the receiver 116.

A reception-side cable (not illustrated) that outputs the NMR signal received by the receive coil 110 is connected to the receive coil 110. Although not illustrated in FIG. 1, a reception-side connector is connected to an end part of the reception-side cable. The reception-side connector is connected to a bed-side connector provided at the bed 103. The bed-side connector is connected to a bed-side cable disposed inside the bed 103, and the bed-side cable is connected to the control device 200.

As a result, the receive coil 110 is communicably connected to the control device 200 and the sequencer 118. The connection between the receive coil 110 and the control device 200 and the sequencer 118 is not limited to a wired connection such as a cable, and an aspect in which the connection is made wirelessly is also possible. In this case, the receive coil 110 or the bed 103 further includes at least an A/D conversion module and a wireless communication module.

The control device 200 controls the measurement unit 100 and performs various calculations such as image reconstruction based on the signal obtained from the measurement unit 100. The control device 200 can be configured by using a computer. The computer applied to the control device 200 may be a personal computer, a workstation, or a server computer.

The control device 200 comprises a processor 202, a memory 204, a storage 205, an input/output interface 206, a display 208, an operation unit 210, and the like as hardware.

The processor 202 includes a central processing unit (CPU). The processor 202 may include a graphics processing unit (GPU). Further, the processor 202 may include one or a plurality of hardware components of a digital signal processor (DSP), an application-specific integrated circuit (ASIC), a programmable logic device (PLD), and the like.

The processor 202 performs overall control of each unit of the control device 200 and the measurement unit 100, and executes various programs stored in the memory 204 to execute various functions.

The memory 204 is a storage device including a random access memory (RAM). The memory 204 may include one or more of a flash memory and a read-only memory (ROM). The storage 205 is, for example, a storage device including one or more of a hard disk device, a solid state drive device, or a removable recording medium. The flash memory, the ROM, and the storage 205 are non-volatile storage devices that store an operation system, a program that causes the processor 202 to function as the control device 200, various pulse sequences, a calculation formula used for image reconstruction, parameters, a trained model, an MR image reconstructed by the image reconstruction, and the like.

The RAM functions as a work area for processing by the processor 202, and temporarily stores the programs and the like stored in the non-volatile storage device. In addition, the RAM functions as a place for temporarily storing the measurement data that is digital sampling data obtained by processing the echo signal obtained from the measurement unit 100, that is, so-called raw data. A portion (RAM) of the memory 204 may be provided in the processor 202.

The input/output interface 206 includes a communication unit that is connectable to a network, a connection unit that is connectable to an external device, and the like. As the connection unit that is connectable to the external device, a universal serial bus (USB), a high-definition multimedia interface (HDMI) (HDMI is a registered trademark), or the like can be applied.

The processor 202 communicates with the device (in the present example, the sequencer 118) and the receiver 116 disposed in the measurement unit 100 via the input/output interface 206 to transmit and receive required information. In addition, a portion of the sequencer 118 may be provided on the control device 200 side.

For example, the display 208 is configured by a liquid crystal display, an organic electroluminescence (OEL) display, a projector, or an appropriate combination thereof. The display 208 displays various types of information in addition to the MRI image captured by the MRI apparatus 10. The display 208 is used as a portion of a user interface (UI) in a case of receiving an input from the operation unit 210. The display 208 is not limited to a single display device and can also be in a multi-display form comprising a plurality of display devices.

The operation unit 210 includes an input device such as a mouse and a keyboard, and functions as a part of a graphical user interface (GUI) that receives an input from an operator using a display operation window of the display 208. For example, the operation unit 210 and the display 208 function as a GUI for the operator to activate and stop (pause) the measurement unit 100, select the pulse sequence, and input the imaging conditions, the processing conditions, and the like. The operation unit 210 may include an audio input device. Further, the operation unit 210 may be a touch panel type input device that is integrally configured with a display screen of the display 208.

Relationship between Data of k-Space and Image Data of Real Space

The k-space is a space representing a wave number (spatial frequency) distribution of image data of a real space, and the image data of the real space and the data of the k-space have a relationship in which the image data and the data of the k-space can be converted to each other by a Fourier transform and an inverse Fourier transform. Since the NMR signal is expressed as a Fourier transform of the nuclear magnetization distribution, the NMR signal can be regarded as a signal in wavenumber space (k-space) by converting the variables of resonance frequency and time into position coordinates and wavenumber based on the Larmor equation and a linear gradient magnetic field. That is, the k-space in MRI is understood as a data space in which the measurement data obtained by digitally sampling the echo signal is stored, and is also referred to as a measurement space. The measurement data is understood as k-space data mapped to the k-space.

In general, the k-space, which is a Fourier transform space of the real space, is defined as a three-dimensional k-space by a coordinate system of wave numbers (kx, ky, kz) corresponding to a coordinate system of positions (x, y, z) in the real space, but, here, as a typical example of the MRI, a case will be described in which a two-dimensional image is generated from two-dimensional k-space data by performing frequency encoding and phase encoding in an imaging tomographic plane designated by slice selection using the gradient magnetic field in the Z direction.

The two-dimensional k-space is represented by a two-dimensional plane in which a kx axis as a horizontal axis is a frequency encoding axis and a ky axis as a vertical axis is a phase encoding axis. The definition of each axis (dimension) is not limited to the above example.

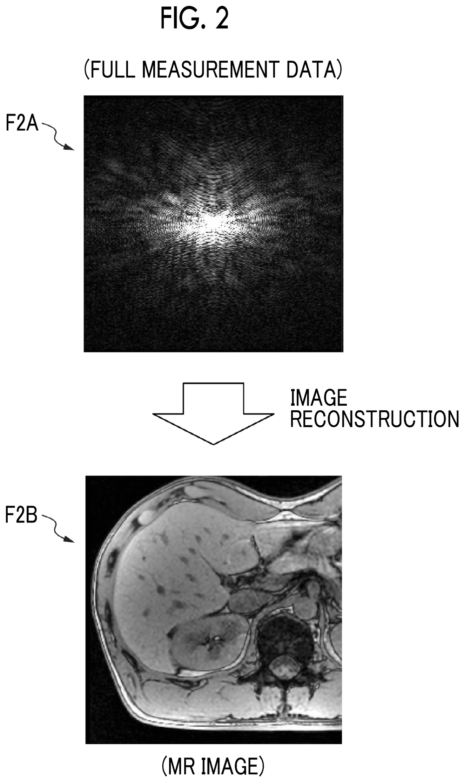

FIG. 2 is a diagram illustrating examples of full measurement data of the k-space and the MR image reconstructed from the full measurement data. The "full measurement data" refers to complete k-space data that is data collected in an entire region of a matrix (data acquisition matrix) of the k-space set by the imaging parameters as a measurement region. The matrix of the k-space is defined by the FOV, the number of pixels in the frequency encoding direction, and the number of pixels in the phase encoding direction.

For example, in a case in which the matrix size of the FOV is set to 256 × 256, the data in the k-space is data (also referred to as "raw data") sampled at equal intervals (data pitch Δk) at 256 points × 256 points of the k-space. In addition, the upper and lower limits of the acquisition of the data in the k-space are determined in accordance with the spatial resolution of the MR image.

The data near the origin of the k-space (portion in which the values of kx and ky are small) has a low spatial frequency, and a component representing a rough structure of the image is present, and the data in a peripheral portion of the k-space (portion in which the value of kx or ky is large) has a high spatial frequency, and a component representing a fine structure of the image is present.

Full measurement data F2A is complex data, and includes real part k-space data and imaginary part k-space data. The full measurement data F2A illustrated in the upper part of FIG. 2 is displayed as a complex amplitude image. An image F2B reconstructed by performing an inverse Fourier transform on the full measurement data F2A is a complex image. The image F2B illustrated in the lower part of FIG. 2 is displayed as an absolute value image obtained by performing absolute value image generation on the complex image.

Collection of Data of k-Space

The MRI apparatus 10 controls the sampling timing of the RF pulse, the gradient magnetic fields Gx, Gy, and Gz, and the echo signal generated from the RF coil 108 in accordance with the pulse sequence selected depending on the examination part and the imaging purpose, and collects the data that fills the k-space.

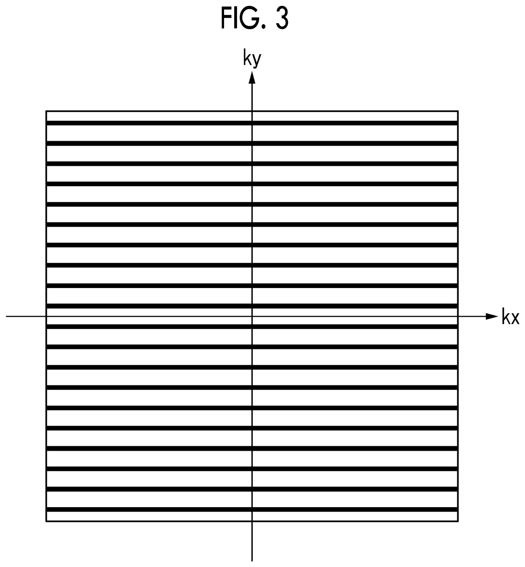

FIG. 3 is a diagram illustrating examples of each point (kx, ky) of data disposed in the k-space and a k-trajectory. Here, as an example, a case will be described in which the kx axis is the frequency encoding axis and the ky axis is the phase encoding axis. For example, in a case of the pulse sequence of the spin echo method, the gradient magnetic field Gx is generated in synchronization with the period during which the echo signal is generated, and the echo signal is sampled during the period to collect data for one line in the kx direction of the k-space. The collection of the data for one line is performed for each repetition time TR. That is, the data in the kx direction of the k-space is collected by one echo. The kx direction is also referred to as a "readout direction". The data in the ky direction is collected by changing the strength of the gradient magnetic field Gy for each TR in the collection of the data in the kx direction. For example, the full measurement data in a case in which the matrix size of the k-space is 256 × 256 is data of 256 points of sampling in the frequency encoding direction × the number of steps 256 in the phase encoding direction. Therefore, it takes a time of "TR × the number of steps of phase encoding" in order to collect the full measurement data that fills the entire region of the k-space having the designated matrix size. In the pulse sequence of the spin echo method or the like, it takes several minutes to collect the full measurement data that fills the k-space as the imaging time.

Example of Reduction in Imaging Time by Partial Sampling of k-Space

In the related art, a half-Fourier method is known as a method of reducing the imaging time. In the half-Fourier method, data of an asymmetrical region that is a partial region in the k-space is collected instead of collecting the full measurement data. For example, a method called half-scan that reduces the number of steps in the phase encoding direction and a method called half-echo that reduces the number of sampling points in the frequency encoding direction are known.

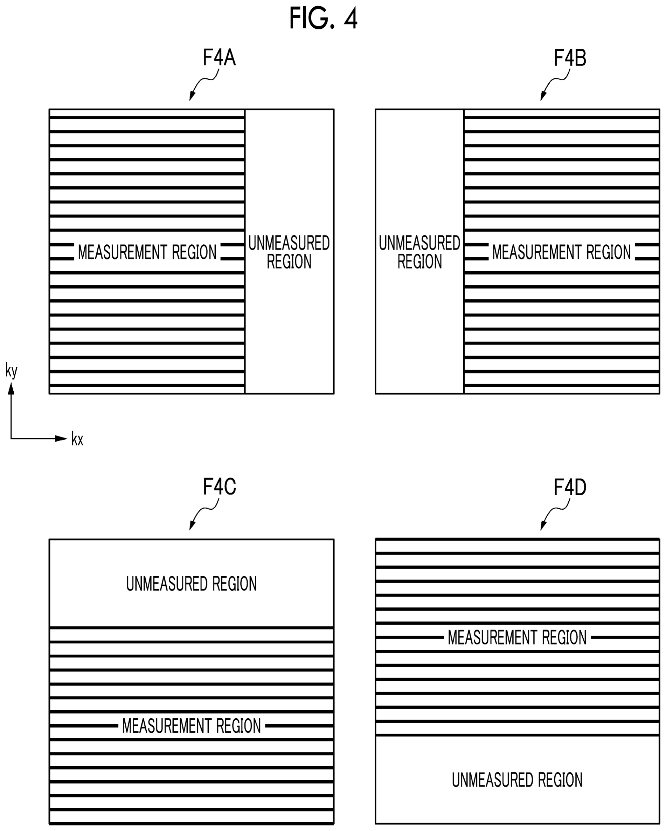

FIG. 4 is a diagram illustrating an example of a data filling method using asymmetric k-space sampling. There may be four patterns as a pattern in which the unmeasured region is set in any one direction among four directions of up, down, left, and right in the two-dimensional plane of the k-space.

In a k-space F4A illustrated in the upper left of FIG. 4, the unmeasured region is present in the right direction (positive kx direction) of the k-space, and the data is collected in a region other than the unmeasured region as the measurement region. As a result, partial k-space data in which the measurement data fills the asymmetrical measurement region in the k-space F4A is obtained.

In a k-space F4B illustrated in the upper right of FIG. 4, the unmeasured region is present in the left direction (negative kx direction) of the k-space. In addition, in a k-space F4C illustrated in the lower left of FIG. 4, the unmeasured region is present in the up direction (positive ky direction) of the k-space, and in a k-space F4D illustrated in the lower right of FIG. 4, the unmeasured region is present in the down direction (negative ky direction) of the k-space.

As in the k-spaces F4A and F4B illustrated in the upper part of FIG. 4, in a case in which the k-space is filled with the measurement data collected by the half-echo method in which the number of sampling points in the frequency encoding direction is small, the collection time of the data for one line in the frequency encoding direction can be reduced, and particularly in a case in which the pulse sequence is EPI, the data of the k-space required for reconstructing one MRI image can be collected in a shorter time.

In addition, as in the k-spaces F4C and F4D illustrated in the lower part of FIG. 4, in a case in which the k-space is filled with the measurement data collected by the half-scan measurement method in which the number of steps in the phase encoding direction is small, the number of phase encodings is reduced, and the imaging time can be reduced regardless of the type of the pulse sequence.

In FIG. 4, the example has been described in which the unmeasured region is set in any one direction among the four directions of up, down, left, and right of the k-space, but the k-space to which the half-Fourier method can be applied is not limited to the four patterns of the k-space illustrated in FIG. 4, and a k-space in which both the half-scan and the half-echo are used and two adjacent regions among the asymmetrical regions in the four directions of up, down, left, and right of the k-space are set as the unmeasured regions may be used. From the symmetry (Hermitian symmetry) of the k-space information, the measurement region of the k-space may be a region exceeding one quadrant of the first quadrant to the fourth quadrant in which the two-dimensional plane of the k-space is divided into four quadrants with the origin of the kx axis and the ky axis as the center.

The processor 202 functions as a measurement controller that transmits the pulse sequence, the imaging conditions (imaging parameters) designated by the operator, and the like to the sequencer 118, and controls the measurement unit 100 via the sequencer 118. In the present embodiment, the sequence for performing the half-scan measurement of reducing the number of steps in the phase encoding direction and/or the half-echo measurement of reducing the number of sampling points in the frequency encoding direction may be selected. In addition, the proportion of the unmeasured region of the k-space in a case of performing the half-scan measurement and/or the half-echo measurement is set to any of 1% to 45% by the operator, and the direction of the unmeasured region is also set by the operator. The setting of the proportion and the direction of the unmeasured region may be achieved by setting the proportion and the direction of the measurement region other than the unmeasured region. The user interface may receive the setting of the proportion and the direction of the measurement region or may receive the setting of the proportion and the direction of the unmeasured region.

The processor 202 transmits an instruction to the sequencer 118 in accordance with the condition set by the imaging parameters, and causes the measurement unit 100 to execute the pulse sequence under the control of the sequencer 118. The subject 102 is imaged by executing the pulse sequence by the measurement unit 100, and the receive coil 110 provided at the examination part of the subject 102 receives the echo signal from the subject 102. The receiver 116 executes the amplification, the detection, and the A/D conversion of the echo signal received by the receive coil 110, and transmits the digital data of the real part and the imaginary part to the control device 200 via the input/output interface 206. In this manner, the measurement data is acquired. In this specification, the measurement data of the k-space including the unmeasured region is referred to as "partial measurement data". The term "partial measurement data" is not limited to the data acquired by the asymmetric sampling, and is also used for partial measurement data generated by discarding a part of the full-sampled full measurement data.

Method of Improving MR Image: CNN Estimation Method

The half-Fourier method has a disadvantage that the image quality of the reconstruction image is significantly degraded (deteriorates) as the unmeasured region becomes large. On the other hand, there is also a method of, for the k-space including the asymmetrical unmeasured region illustrated in FIG. 4, generating the reconstructed image by performing an inverse Fourier transform on the k-space data complemented by filling the unmeasured region with zero data, without applying Hermitian-symmetry-based complement. However, the reconstruction image reconstructed by such a simple zero-filling complement has degraded image quality due to the zero data filling the unmeasured region.

As one of the techniques for estimating the asymmetrical unmeasured region in the k-space for improving the image quality of the reconstruction image based on the partial k-space data obtained from the sampling region set asymmetrically in the k-space, US2022/0198725A proposes the method of improving the image quality of the MR image using a trained neural network model trained through machine learning. The neural network model is, for example, a multi-layer convolutional neural network (CNN) model.

CNN Estimation Method

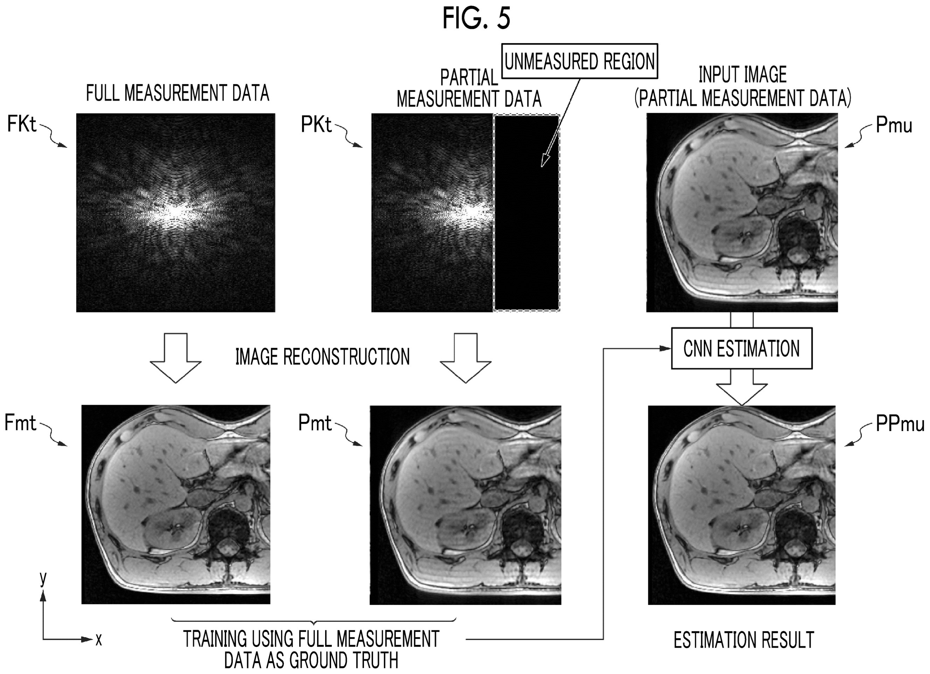

FIG. 5 is a conceptual diagram illustrating the method of improving the degradation of image quality of the MR image using the CNN. In this specification, a method of estimating the data of the unmeasured region using a trained CNN to improve the image quality of the reconstruction image is referred to as a "CNN estimation method".

In the CNN estimation method, first, as a preliminary preparation, the trained CNN is generated by machine learning. In this training phase, machine learning is performed using, as the training data, a pair of a full measurement image Fmt that is the reconstruction image reconstructed from full measurement data Fkt and a partial measurement image Pmt that is the reconstruction image reconstructed from partial measurement data PKt corresponding to the full measurement image Fmt, and the full measurement image Fmt being ground-truth data, so that the trained CNN trained to estimate the full measurement image Fmt from the partial measurement image Pmt is generated. The subscript "t" in the symbols such as Fkt and PKt is an index representing a "pair" of data in the training dataset.

The partial measurement data PKt can be generated by replacing the data of a partial region of the full measurement data Fkt with the zero data. That is, by regarding the partial region of the k-space matrix of the full measurement data Fkt as the unmeasured region and replacing the data of the partial region with the zero data, the partial measurement data PKt equivalent to the measurement data obtained by the asymmetric sampling can be generated. A direction in which the region regarded as the unmeasured region in the k-space is set and a proportion of the unmeasured region with respect to the entire region of the matrix size of the k-space can be arbitrarily set, and the partial measurement data obtained by the asymmetric sampling under various conditions can be pseudo-generated.

The full measurement data Fkt is an example of "first k-space data" in the present disclosure, and the full measurement image Fmt is an example of a "first full measurement image" in the present disclosure. The partial measurement data PKt is an example of "second k-space data" in the present disclosure, and the partial measurement image Pmt is an example of a "first partial measurement image" in the present disclosure. In the partial measurement data Pkt illustrated in FIG. 5, a partial region (corresponding to the measurement region) of the k-space filled with the same data as the full measurement data Fkt is an example of a "first region" in the present disclosure, and a region (corresponding to the unmeasured region) replaced with the zero data is an example of a "second region" in the present disclosure.

The number of image pairs in the training dataset used for the machine learning of the CNN is preferably about 40,000. In addition, in the training dataset in a case in which one CNN is trained through machine learning, it is desirable that the directions of the unmeasured region of the partial measurement data PKt corresponding to the partial measurement image Pmt in the k-space are the same direction, and the proportions of the unmeasured region in the k-space are also the same. In this specification, the direction of the unmeasured region in the k-space is referred to as an "unmeasured direction", and the proportion of the unmeasured region with respect to the entire region of the matrix size of the k-space is referred to as an "unmeasured proportion". The unmeasured proportion can be represented in percentage, and is synonymous with an unmeasured percentage.

For example, since the unmeasured direction of the partial measurement data PKt illustrated in FIG. 5 is the right in FIG. 5, the unmeasured direction of the k-space data corresponding to each of a plurality of partial measurement images Pmt included in the training dataset is the right direction. In addition, in a case in which the unmeasured proportion of the partial measurement data PKt is 40%, the unmeasured proportion of the k-space corresponding to each of the plurality of partial measurement images Pmt included in the training dataset is also 40%.

As a result, it is possible to obtain the trained CNN having high estimation accuracy for the input of the partial measurement image in which the unmeasured direction is the right direction and the unmeasured proportion is 40%.

Similarly, a plurality of types of trained CNNs can be generated by using the training dataset in which the conditions of the unmeasured direction and the unmeasured proportion are different.

The right column of FIG. 5 represents an inference phase in which the full measurement image is estimated based on a partial measurement image Pmu using the trained CNN.

The partial measurement image Pmu that is the input image to the trained CNN is a reconstruction image reconstructed by performing an inverse Fourier transform on zero-filling partial measurement data complemented by filling the unmeasured region of the partial measurement data collected from the asymmetrical measurement region in the k-space with the zero data. The image quality of this input image is degraded as compared with the reconstruction image reconstructed from the full measurement data.

The "inverse Fourier transform" in the processing of the computer is an "inverse discrete Fourier transform", and an inverse fast Fourier transform (IFFT) is applied in the present embodiment. Similarly, the "Fourier transform" in the processing of the computer is a "discrete Fourier transform", and a fast Fourier transform (FFT) is applied in the present embodiment.

The trained CNN to which the partial measurement image Pmu is input estimates the full measurement image from the partial measurement image Pmu and outputs an estimation image PPmu as the estimation result. The estimation image PPmu is an image in which the degradation of image quality of the input image is reduced (improved). In a case in which the function of the trained CNN is reconsidered as an action on the data of the k-space, it is understood that the trained CNN has a function of estimating the data of the unmeasured region.

Example of CNN

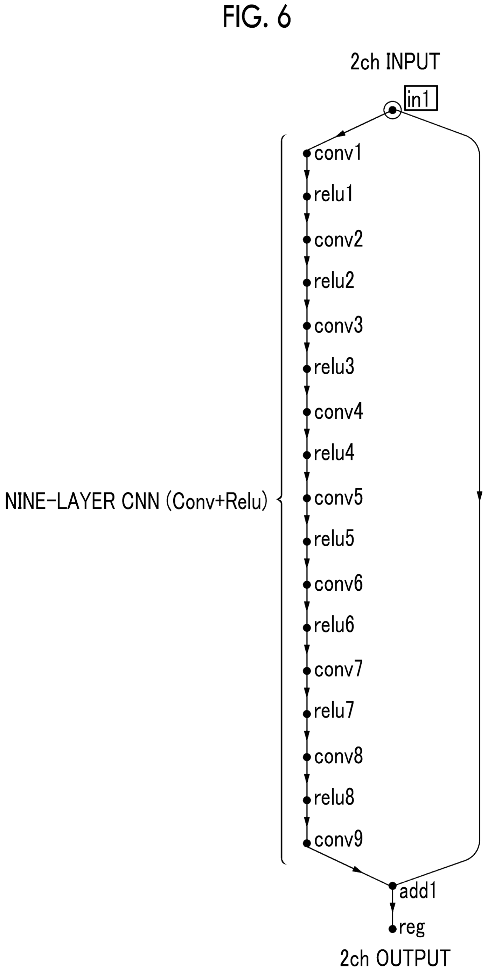

FIG. 6 is a diagram illustrating an example of a network structure of the CNN applied as the trained model. The CNN illustrated in FIG. 6 is a neural network that receives the input of the complex image and outputs the complex image, and is a multi-layer neural network model having two-channel input and two-channel output, in which each of an input channel and an output channel includes a real part and an imaginary part.

The CNN illustrated in FIG. 6 has a network structure of residual learning in which input data is output by being added to the output of a multi-layer CNN in which a plurality of stages of convolutional layers (Conv) and activation layers (Relu) are sequentially connected. The notation "Relu" represents a rectified linear unit applied to the activation layer.

In the neural network model of FIG. 6, the degradation of image quality of the complex image is estimated for the two-channel complex image input to an input layer (in1) through nine convolutional layers (Conv1 to 9) and eight activation layers (Relu1 to 8), and the two-channel correction information for correcting the degradation of image quality is output to an addition layer (add1). The input layer (in1) is connected to another input of the addition layer (add1), and the two-channel complex image input to the input layer (in1) is added. The addition layer (add1) adds the two-channel complex image input to the input layer (in1) and the two-channel correction information output from the convolutional layer (Conv9), and outputs the two-channel image (complex image) as an addition result as the output image via a reg layer. The reg layer may be understood as the output layer that outputs the addition result of the addition layer (add1).

In FIG. 6, the neural network model of the residual learning including the nine-layer CNN is illustrated, but the number of convolutional layers, the number of rectified linear units, and the structure of the network are not particularly limited, and are not limited to the embodiment illustrated in FIG. 6. For example, the network structure may not have the addition layer or may have a pooling layer, and a network such as a U-Net may be used. The CNN applied to the MRI apparatus 10 can have various layer structures. Further, the trained model applied to the MRI apparatus 10 is not limited to the CNN, and may be another machine learning model, and any model may be used as long as the model is trained using a machine learning dataset. The "neural network", the "trained model", and the like are, in substance, programs.

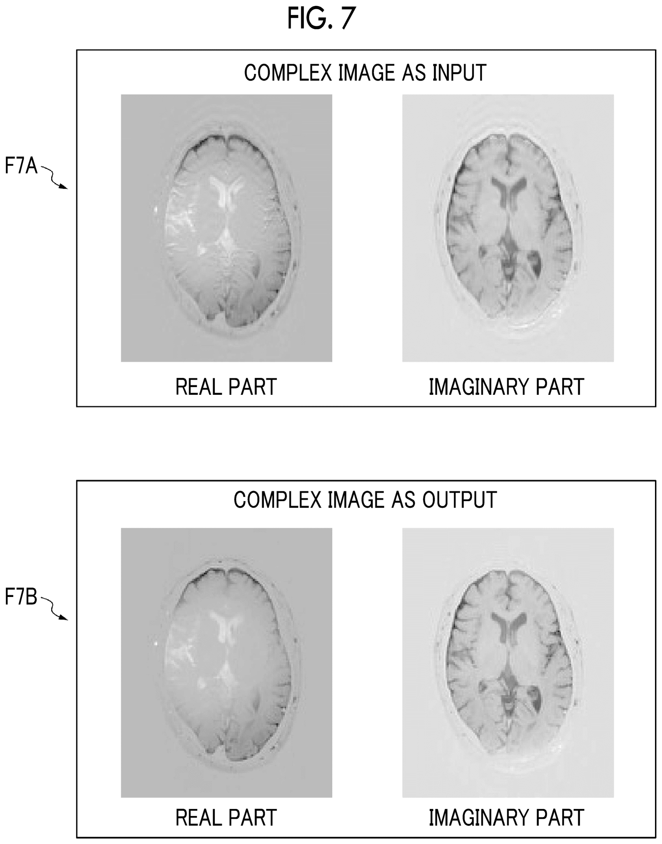

FIG. 7 is a diagram illustrating an example of the input image and the output image of the CNN illustrated in FIG. 6. As illustrated in the upper part of FIG. 7, a two-channel complex image F7A including a real part image and an imaginary part image is input to the input layer (in1) of the CNN illustrated in FIG. 6.

The measurement data measured by the MRI apparatus is complex data, and the real part data and the imaginary part data are arranged in the real part k-space and the imaginary part k-space, respectively. The complex image F7A illustrated in FIG. 7 is a real part image obtained by performing an inverse Fourier transform on the data of the real part k-space and an imaginary part image obtained by performing an inverse Fourier transform on the data of the imaginary part k-space. The complex image F7A is an example of an image reconstructed from k-space data obtained by zero-filling complement of the partial measurement data with the unmeasured proportion of 40%.

The CNN illustrated in FIG. 6 receives the input of the complex image F7A and outputs a complex image F7B illustrated in the lower part of FIG. 7.

Method of Generating Training Image Set

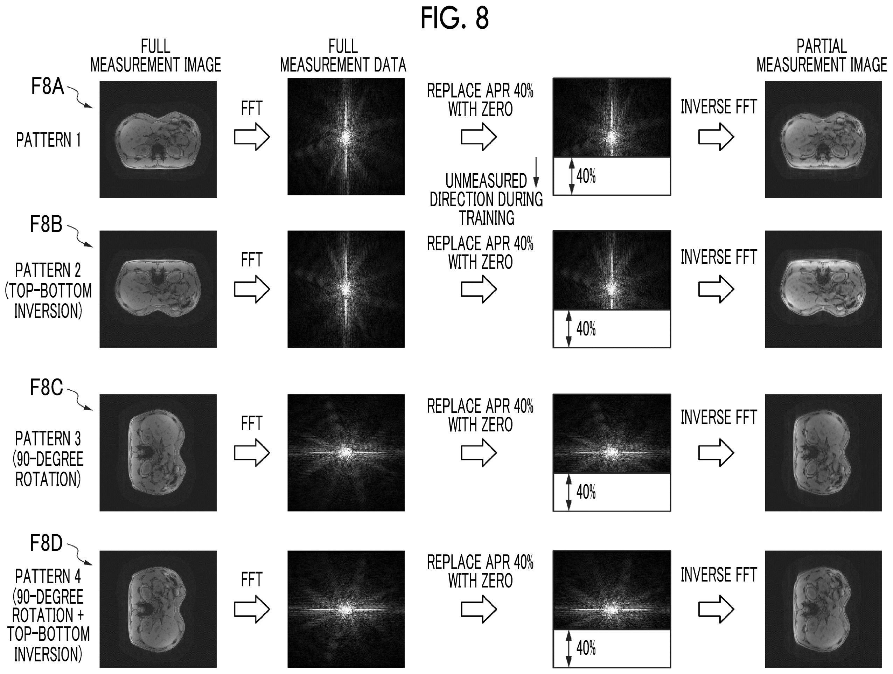

FIG. 8 is a diagram illustrating an example of a method of generating the training image set for training the CNN. The partial measurement image used for the machine learning can be created from the full measurement image. Each of the full measurement image and the partial measurement image is a complex image, but in FIG. 8, for convenience of illustration, an absolute value image is displayed.

FIG. 8 illustrates an outline of a method of generating the training image sets corresponding to four patterns 1 to 4 in which the unmeasured directions are different from one full measurement image.

An image generation process F8A illustrated in the first row, which is the uppermost part of FIG. 8, is a method of generating the partial measurement image corresponding to the reconstruction image of the partial measurement data in a case (pattern 1) in which the unmeasured direction is present in the negative direction of the ky axis in the k-space (kx, ky).

The full measurement image in the leftmost part of the first row is the full measurement image reconstructed from the full measurement data in the k-space, and is used as the ground-truth data as it is.

Meanwhile, the partial measurement image that is the training image paired with the ground-truth data is generated as follows.

The unmeasured region that is asymmetrically set in advance is filled with zero data for the full measurement data in the k-space obtained by performing a fast Fourier transform on the full measurement image. That is, the measurement data corresponding to the preset unmeasured region of the full measurement data in the k-space is replaced with the zero data. In a case of the pattern 1, the unmeasured direction is the down direction on FIG. 8, and the unmeasured proportion is 40%. The partial measurement image reconstructed by performing an inverse fast Fourier transform on the partial k-space data generated in this way is used as the training image.

An image generation process F8B illustrated in the second row of FIG. 8 is a method of generating the partial measurement image corresponding to the reconstruction image of the partial measurement data in a case (pattern 2) in which the unmeasured direction is present in the positive direction of the ky axis in the k-space (kx, ky).

The full measurement image illustrated in the leftmost part of the second row is a top-bottom inverted image in which the top and bottom of the full measurement image illustrated in the first row are inverted, and this top-bottom inverted image is used as the ground-truth data.

Then, the measurement data of the unmeasured region that is asymmetrically set in advance is replaced with the zero data for the full measurement data in the k-space obtained by performing a fast Fourier transform on the top-bottom inverted image. In a case of the pattern 2, the unmeasured direction of the top-bottom inverted k-space is the down direction on FIG. 8, and the unmeasured proportion is 40%. The partial measurement image reconstructed by performing an inverse fast Fourier transform on the partial k-space data generated in this way is used as the training image.

An image generation process F8C illustrated in the third row of FIG. 8 is a method of generating the partial measurement image corresponding to the reconstruction image of the partial measurement data in a case (pattern 3) in which the unmeasured direction is present in the positive direction of the kx axis in the k-space (kx, ky).

The full measurement image illustrated in the leftmost part of the third row is a 90-degree rotated image in which the full measurement image illustrated in the first row is rotated by 90 degrees clockwise, and this 90-degree rotated image is used as the ground-truth data.

Then, the measurement data of the unmeasured region that is asymmetrically set in advance is replaced with the zero data for the full measurement data in the k-space obtained by performing a fast Fourier transform on the 90-degree rotated image. In a case of the pattern 3, the unmeasured direction of the k-space rotated by 90 degrees is the down direction on FIG. 8, and the unmeasured proportion is 40%. The partial measurement image reconstructed by performing an inverse fast Fourier transform on the partial k-space data generated in this way is used as the training image.

An image generation process F8D illustrated in the fourth row, which is the lowermost part of FIG. 8, is a method of generating the partial measurement image corresponding to the reconstruction image of the partial measurement data in a case (pattern 4) in which the unmeasured direction is present in the negative direction of the kx axis in the k-space (kx, ky).

The full measurement image illustrated in the leftmost part of the fourth row is an image obtained by further inverting the top and bottom of the 90-degree rotated image illustrated in the third row (an image in which the full measurement image of the first row is rotated by 90 degrees and then top-bottom inverted), and this image is used as the ground-truth data.

Then, the measurement data of the unmeasured region that is asymmetrically set in advance is replaced with the zero data for the full measurement data in the k-space obtained by performing a fast Fourier transform on the full measurement image illustrated in the fourth row. In a case of the pattern 4, the unmeasured direction of the k-space rotated by 90 degrees and top-bottom inverted is the down direction on FIG. 8, and the unmeasured proportion is 40%. The partial measurement image reconstructed by performing an inverse fast Fourier transform on the partial k-space data generated in this way is used as the training image.

With the method of generating the training image set, the training image sets corresponding to the patterns 1 to 4 can be efficiently generated from one full measurement image.

In addition, the training image sets illustrated in the patterns 1 to 4 have the proportion of the unmeasured region of 40% with respect to the entire region of the k-space, but the training image set can be generated in the same manner for a proportion other than the proportion of the unmeasured region of 40%.

Further, in the example illustrated in FIG. 8, the full measurement data of the k-space corresponding to the full measurement image is acquired by performing a Fourier transform on the full measurement image corresponding to the patterns 1 to 4, but in a case in which the full measurement data in the k-space acquired during the imaging is stored, the stored full measurement data may be top-bottom inverted and/or rotated by 90 degrees to acquire the full measurement data in the k-space corresponding to the patterns 1 to 4.

Outline of POCS Method

As another technique for estimating the data of the unmeasured region from the partial measurement data collected by the asymmetric sampling of the k-space, the projection onto convex sets (POCS) method is known. The POCS method is described in, for example, E.M Haacke, E.D Lindskog, W Lin, "A fast, iterative, partial-fourier technique capable of local phase recovery", Journal of Magnetic Resonance, Volume 92, Issue 1,1991 and Partial k-space Reconstruction, the Internet <URL: https://users.fmrib.ox.ac.uk/~karla/reading_group/lecture_notes/Recon_Pauly_read.pdf>.

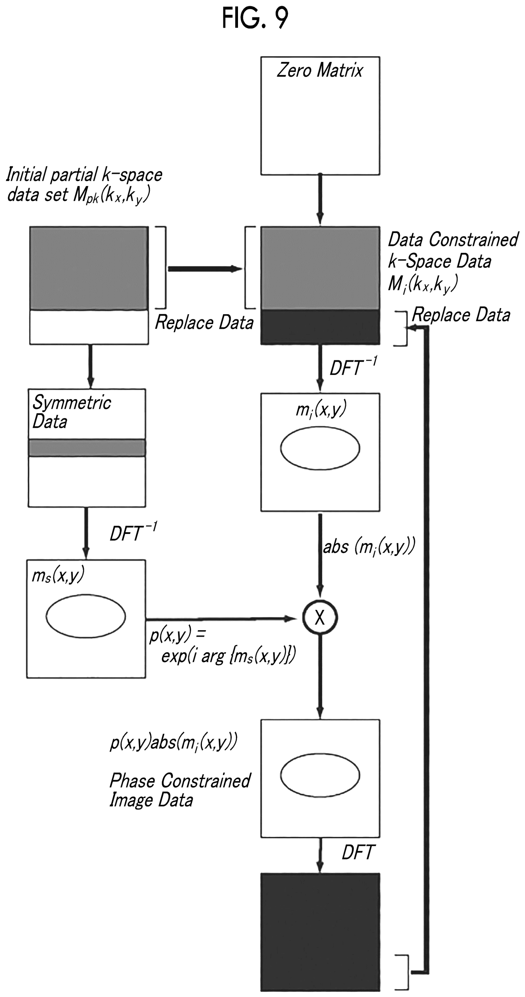

FIG. 9 is a diagram illustrating an example of a method of estimating data of the unmeasured region using the POCS method from the partial measurement data that is data collected in the asymmetrical measurement region in the k-space. FIG. 9 is cited from the description of "Figure 2.17: POCS algorithm" of Partial k-space Reconstruction, the Internet <URL: https://users.fmrib.ox.ac.uk/~karla/reading_group/lecture_notes/Recon_Pauly_read.pdf>.

In the algorithm of the POCS method illustrated in FIG. 9, a low-resolution image ms(x, y) is generated by performing an inverse discrete Fourier transform based on data of a symmetric region of a central portion of partial k-space data Mpk(kx, ky) acquired by the asymmetric sampling of the k-space, and a phase image $\theta$(x, y) is generated from the image ms(x, y).

Meanwhile, an image mi(x, y) is generated by performing an inverse discrete Fourier transform based on k-space data Mi(kx, ky) obtained by combining the partial k-space data Mpk(kx, ky) and replacement data for complementing the unmeasured region of the partial k-space data Mpk(kx, ky), and an absolute value image abs(mi(x, y)) is generated from the image mi(x, y). In addition, the initial replacement data in the unmeasured region may be zero data.

Then, the phase correction of multiplying the absolute value image abs(mi(x, y)) by exp(i·$\theta$(x, y)) = p(x, y) is performed, and the k-space data is estimated by performing a discrete Fourier transform on the phase-corrected image p(x, y)abs(mi(x, y)).

In this way, by repeating the processing of replacing the data portion of the measurement region in the k-space data estimated with the phase correction with the original partial k-space data Mpk(kx, ky), the k-space data Mi(kx, ky) is sequentially updated, and the unmeasured region is estimated. With the POCS method, the noise of the unmeasured region in the k-space is also estimated.

The processing of replacing the data portion of the measurement region in the k-space data estimated with the phase correction with the original measured partial k-space data Mpk(kx, ky) may be understood as, in other words, processing of fixing the data portion of the measurement region in the k-space data Mi(kx, ky) with the partial k-space data Mpk(kx, ky), replacing the data portion (portion of the replacement data) of the unmeasured region with the data of the corresponding region of the k-space data estimated by the phase correction, and updating the k-space data Mi(kx, ky).

The partial k-space data Mpk(kx, ky) and the k-space data Mi(kx, ky) are each the complex data, and the image ms(x, y) and the image mi(x, y) are each the complex image.

Description of Issue

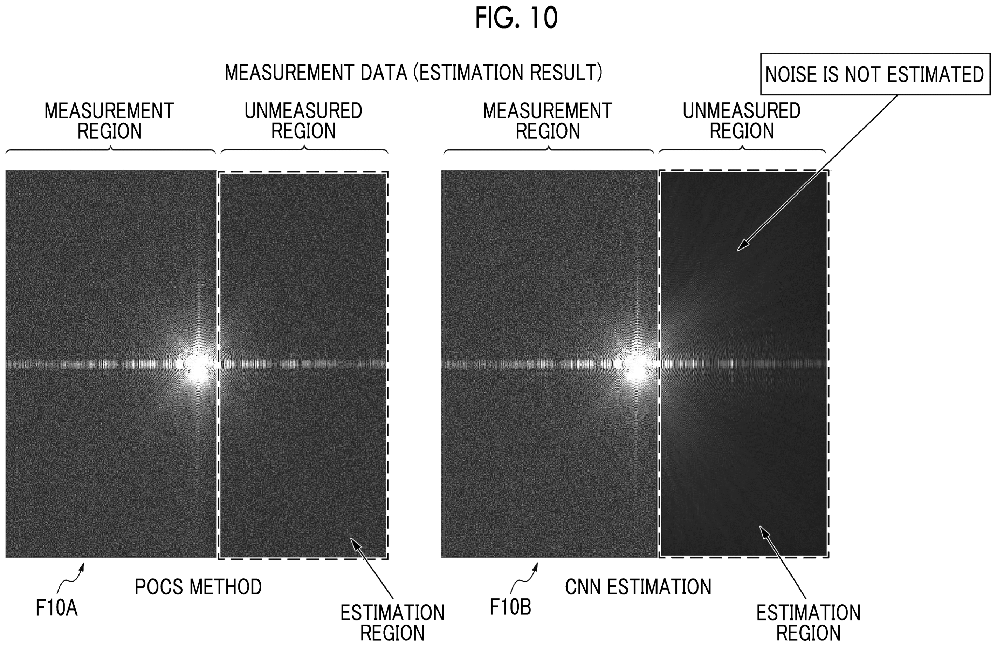

FIG. 10 is a diagram illustrating examples of the k-space data in which the unmeasured region is estimated by the POCS method from the partial measurement data and the k-space data in which the unmeasured region is estimated by the CNN estimation method. Here, k-space data F10A illustrated on the left of FIG. 10 is an estimation result of the POCS method, and k-space data F10B illustrated on the right of FIG. 10 is an estimation result of the CNN estimation method. Each region surrounded by a broken line on the right side (positive kx direction) in the k-space is an estimation region corresponding to the unmeasured region.

As can be seen by comparing two estimation regions, the noise of the unmeasured region is estimated in the POCS method, whereas the noise is not estimated in the CNN estimation method.

FIG. 11 is an example of a test phantom image reconstructed from each of the k-space data F10A and F10B illustrated in FIG. 10. An image F11A illustrated on the left of FIG. 11 is an image reconstructed from the k-space data F10A including the estimation result of the POCS method, and an image F11B illustrated on the right of FIG. 11 is an image reconstructed from the k-space data F10B including the estimation result of the CNN estimation method.

In the CNN estimation method, since the noise of the unmeasured region is not estimated, the image F11B having a high SNR is obtained. On the other hand, due to the asymmetry of the signal intensity caused by not estimating the noise, the noise on the image F11B appears in a stripe shape. In FIG. 11, it may be difficult to see the striped noise due to the limitation of the illustration, but the striped noise appears in a direction (horizontal direction in FIG. 10) of the unmeasured region in the k-space.

On the other hand, in the POCS method, since the noise of the unmeasured region is also estimated, the reconstruction image may include more natural point-like noise without the occurrence of the striped noise. On the other hand, in the POCS method illustrated in FIG. 9, since the phase correction (low-frequency phase estimation) is performed using the bandlimited (central portion) measurement data in the k-space, the phase information of the high spatial frequency is not corrected, and thus there is a disadvantage that the SNR is low and the artifacts caused by the unmeasured data are likely to occur in the final reconstruction image.

Outline of Image Processing Method According to First Embodiment

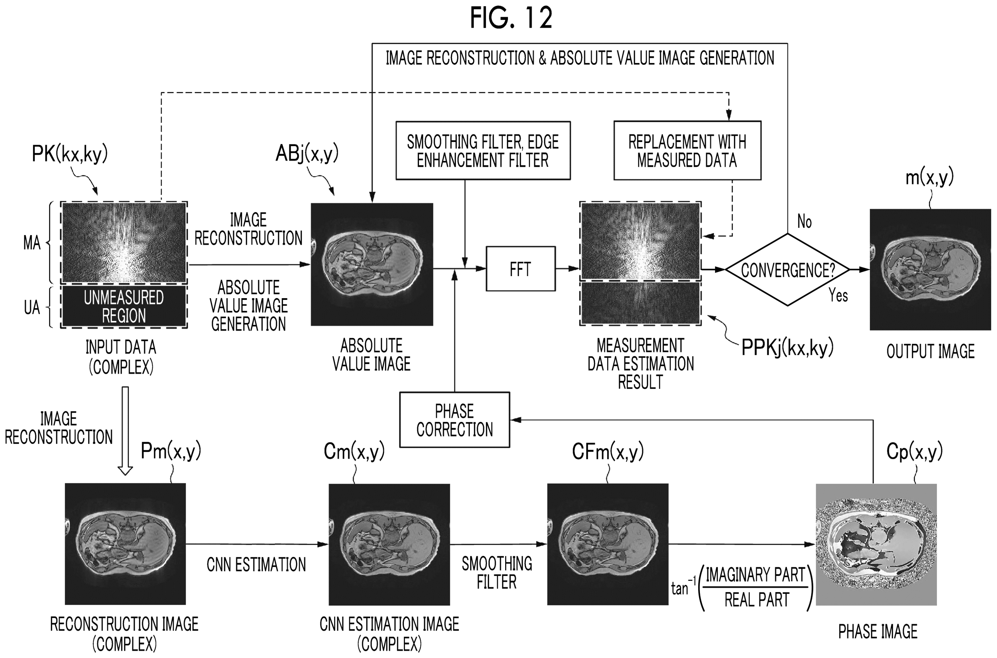

FIG. 12 is a diagram illustrating an outline of an image processing method according to a first embodiment. The image processing method implemented in the MRI apparatus 10 according to the present embodiment is a method in which the phase correction using the CNN estimation method and the POCS method are combined, and a phase image Cp(x, y) generated from an estimation image Cm(x, y) obtained by the CNN estimation method is applied to the phase correction of the POCS method instead of the phase image θ(x, y) illustrated in FIG. 9, and the signal of the unmeasured region UA in the partial measurement data PK(kx, ky) of the k-space sequentially restored to reduce the striped noise and the artifacts.

The processing illustrated in FIG. 12 is executed by the processor 202. The processor 202 acquires the partial measurement data PK(kx, ky) in which the measurement data is collected in an asymmetrical measurement region MA in the k-space as input data to be processed. The unmeasured region UA in which the measurement data is missing in the matrix of the k-space defined by the imaging parameters is temporarily filled with the zero data. The processing of filling the data missing region of the k-space with zero values is referred to as "filling with zero", "zero-filling", or the like. The simplest method of reconstructing the image from the partial measurement data by the asymmetric sampling of the k-space is the data complement by the zero-filling of the unmeasured region.

The k-space data including the partial measurement data PK(kx, ky) in which the unmeasured region UA is complemented by zero-filling is referred to as partial measurement data PKze(kx, ky). That is, the k-space data including the partial measurement data PK(kx, ky) that is the measured data sampled from the measurement region MA and the zero data filling the unmeasured region UA is referred to as partial measurement data PKze(kx, ky). The subscript "ze" represents that the zero-filling is performed.

The partial measurement data PKze(kx, ky) is the complex data. For convenience of illustration, FIG. 12 illustrates only the real part of the partial measurement data PK(kx, ky). The same applies to the illustration of estimated k-space data PPKj(kx, ky) indicating the estimation result of the measurement data estimated through the phase correction described later.

The processor 202 acquires the partial measurement data PKze(kx, ky), and generates a reconstruction image Pm(x, y) by performing an inverse Fourier transform from the partial measurement data PKze(kx, ky).

The processor 202 inputs the reconstruction image Pm(x, y) to the trained CNN to obtain the output of the estimation image Cm(x, y) from the trained CNN. Further, the processor 202 performs the filter processing using the smoothing filter on the estimation image Cm(x, y) to generate a smoothed estimation image CFm(x, y).

Each of the reconstruction image Pm(x, y), the estimation image Cm(x, y), and a filter-processed estimation image CFm(x, y) is the complex image, but in FIG. 12, for convenience of illustration, each absolute value image is displayed. The same applies to the other drawings.

The processor 202 generates the phase image Cp(x, y) indicating the phase at each position (x, y) by calculating $\tan^{-1}$(imaginary part/real part) from the real part image and the imaginary part image of the smoothed estimation image CFm(x, y).

On the other hand, the processor 202 performs the image reconstruction and the absolute value image generation based on the partial measurement data PKze(kx, ky) to generate an absolute value image ABj(x, y). The processing of generating the absolute value image ABj(x, y) and the processing of generating the phase image Cp(x, y) may be executed by concurrent processing or parallel processing or may be executed by sequential processing, and the order of processing is not limited.

In addition, the reconstruction processing of generating the reconstruction image Pm(x, y) from the partial measurement data PKze(kx, ky) may be common to a process of generating the absolute value image ABj(x, y) and a process of generating the phase image Cp(x, y), or may be divided into the processing of the absolute value image generation and the processing of the CNN estimation after the generation of the reconstruction image Pm(x, y).

The processor 202 performs the phase correction of the absolute value image ABj(x, y) using the phase image Cp(x, y). Here, the phase correction is processing of multiplying the absolute value image ABj(x, y) by exp(i·Cp(x, y)). Further, the processor 202 performs the filter processing using the smoothing filter and/or the edge enhancement filter on the image after the phase correction. The processor 202 performs a Fourier transform on the image subjected to the phase correction and the filter processing to generate the estimated k-space data including the estimation data of the unmeasured region. The data of the measurement region MA in the estimated k-space data is replaced with the original partial measurement data PK(kx, ky) that is the measured data to generate the estimated k-space data PPKj(kx, ky) in which the estimation data of the unmeasured region and the measured data are combined.

The processor 202 determines whether or not the estimation result of the unmeasured region UA has converged, and in a case in which it is determined that the estimation result has not converged (in a case in which the determination result is "No"), the processor 202 performs the image reconstruction and the absolute value image generation on the estimated k-space data PPKj(kx, ky), newly generates the absolute value image, and updates the absolute value image ABj(x, y). The iterative processing including the generation of the estimated k-space data PPKj(kx, ky) by the phase correction and the update of the absolute value image ABj(x, y) is executed until the estimation result of the unmeasured region UA converges. The subscript "j" in the symbols such as ABj(x, y) is an index indicating the number of times of the iterative processing in the algorithm of the POCS method, and the value of j is incremented by "+1" by executing the iterative processing.

In a case in which it is determined that the estimation result of the unmeasured region UA has converged (in a case in which the determination result is "Yes"), the processor 202 ends the iterative processing and generates an output image m(x, y) from the finally obtained estimated k-space data PPKj(kx, ky).

The output image m(x, y) finally generated is typically an absolute value image conforming to a digital imaging and communications in medicine (DICOM) format. The complex image as the reconstruction image may be output instead of the absolute value image or in combination with the absolute value image as the output image m(x, y).

Functional Block Diagram of Image Processing Apparatus

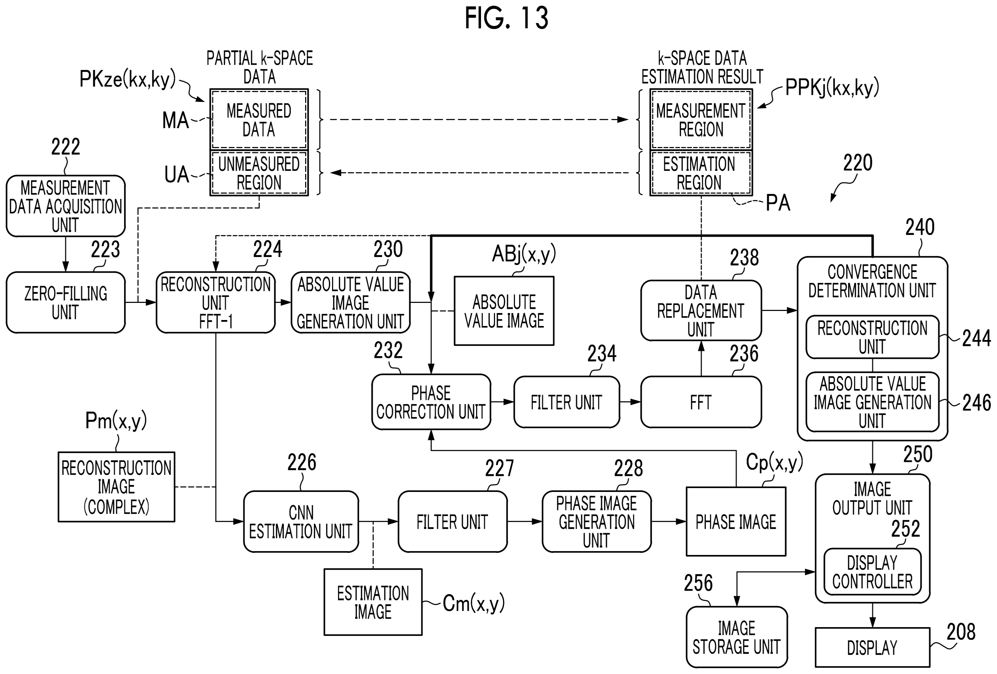

FIG. 13 is a block diagram illustrating a functional configuration of an image processing apparatus 220 according to the first embodiment. The image processing apparatus 220 is implemented as an image processing unit of the control device 200.

The image processing apparatus 220 comprises a measurement data acquisition unit 222, a zero-filling unit 223, a reconstruction unit 224, a CNN estimation unit 226, a filter unit 227, a phase image generation unit 228, an absolute value image generation unit 230, a phase correction unit 232, a filter unit 234, a Fourier transform unit 236, a data replacement unit 238, a convergence determination unit 240, an image output unit 250, and an image storage unit 256. Each processing unit is achieved by hardware and software including the processor 202 and the memory 204.

The measurement data acquisition unit 222 acquires the measurement data by receiving the input of the measurement data in which the nuclear magnetic resonance signal is digitally sampled. The measurement data acquisition unit 222 may acquire the measurement data from the measurement unit 100 or may acquire the measurement data from a device such as a data server. The acquired measurement data may be the partial measurement data.

The zero-filling unit 223 performs zero-filling (zero-fill) processing of filling the unmeasured region in the k-space in which the partial measurement data is missing with the zero data. The k-space data complemented by the zero-filling processing is obtained in the matrix size of the reconstruction image as the restoration target.

The reconstruction unit 224 performs the image reconstruction processing by performing an inverse discrete Fourier transform on the k-space data to generate the reconstruction image. The partial measurement data PKze(kx, ky) complemented by the zero-filling unit 223 is subjected to an inverse discrete Fourier transform in the reconstruction unit 224 to generate the reconstruction image Pm(x, y).

The CNN estimation unit 226 includes a trained model, receives the input of the reconstruction image Pm(x, y) as the partial measurement image, and outputs the estimation image Cm(x, y) as the estimation result of the corresponding full measurement image.

The trained model may be a model trained through machine learning to receive the input of the partial measurement image that is the zero-fill reconstruction image of the partial measurement data and output an estimated full measurement image by estimating the reconstruction image of the full measurement data. The trained model may be a trained CNN trained using the training image sets corresponding to the patterns 1 to 4 generated by the method of generating the training image sets illustrated in FIG. 8.

In addition, the trained model may be a model trained through machine learning to receive the input of the partial measurement image that is the zero-fill reconstruction image of the partial measurement data and output an estimated residual image indicating a residual between the estimated full measurement image of the full measurement data and the input partial measurement image. The trained model that outputs the estimated residual image may be a trained CNN trained using a residual image calculated from a pair of the partial measurement image and the full measurement image generated by the method of generating the training image set illustrated in FIG. 8 as the ground-truth data. In this case, the CNN estimation unit 226 may be configured to estimate the full measurement image by adding the input partial measurement image and the estimated residual image output from the trained CNN or subtracting the estimated residual image from the input partial measurement image, and output the estimation image.

The filter unit 227 includes the smoothing filter. The filter unit 227 may include the edge enhancement filter. The filter applied to the filter unit 227 may be set in advance, or the filter to be used may be variably set by a selection operation by the operator or by automatic selection in accordance with the imaging sequence or the like. In addition, the filter processing in the filter unit 227 can be skipped.

The filter unit 227 performs the filter processing on the estimation image Cm(x, y) output from the CNN estimation unit 226. The phase image generation unit 228 generates the phase image Cp(x, y) from the estimation image CFm(x, y) after the filter processing. The phase image generation unit 228 calculates $\tan^{-1}$(imaginary part/real part) from the real part image and the imaginary part image of the estimation image CFm(x, y) after the filter processing, and generates the phase image Cp(x, y) indicating the phase distribution.

The absolute value image generation unit 230 generates the absolute value image ABj(x, y) from the reconstruction image Pm(x, y) generated by the reconstruction unit 224. In a case in which a real part of the reconstruction image M that is the complex image is denoted by ReM and an imaginary part is denoted by ImM, the absolute value image abs(M) is calculated by the following expression.

$$abs(M) = \{(ReM)^2 + (ImM)^2\}^{1/2}$$

The phase correction unit 232 performs the phase correction by multiplying the absolute value image ABj(x, y) by exp(i·Cp(x, y)) of the phase image Cp(x, y).

The filter unit 234 includes at least one of the smoothing filter or the edge enhancement filter, and performs the smoothing filter processing or the edge enhancement filter processing or both the smoothing filter processing and the edge enhancement filter processing on the phase-corrected image. It is preferable that the filter unit 234 includes the smoothing filter. As in the filter unit 227, the filter applied to the filter unit 234 may be variably set. In addition, the filter processing in the filter unit 234 can be skipped.

The Fourier transform unit 236 performs a Fourier transform on the image data of the corrected image subjected to the phase correction and the filter processing, to generate the k-space data. The Fourier transform unit 236 may be a processing unit that performs a fast Fourier transform.

The k-space data generated by the Fourier transform unit 236 is the estimated k-space data (estimated measurement data) in which the unmeasured data of the unmeasured region UA is estimated.

The data replacement unit 238 performs processing of retaining the data of the estimation region that is the estimation result of the unmeasured region UA in the estimated k-space data generated by the Fourier transform unit 236, and replacing the data of the measurement region MA with the partial measurement data PK(kx, ky) that is the original measured data. As a result, the original partial measurement data PK(kx, ky) is filled as the data of the measurement region MA in the k-space, and the estimated k-space data PPKj(kx, ky) filled with the estimation data estimated from the phase-corrected image in the estimation region PA corresponding to the unmeasured region UA is obtained.

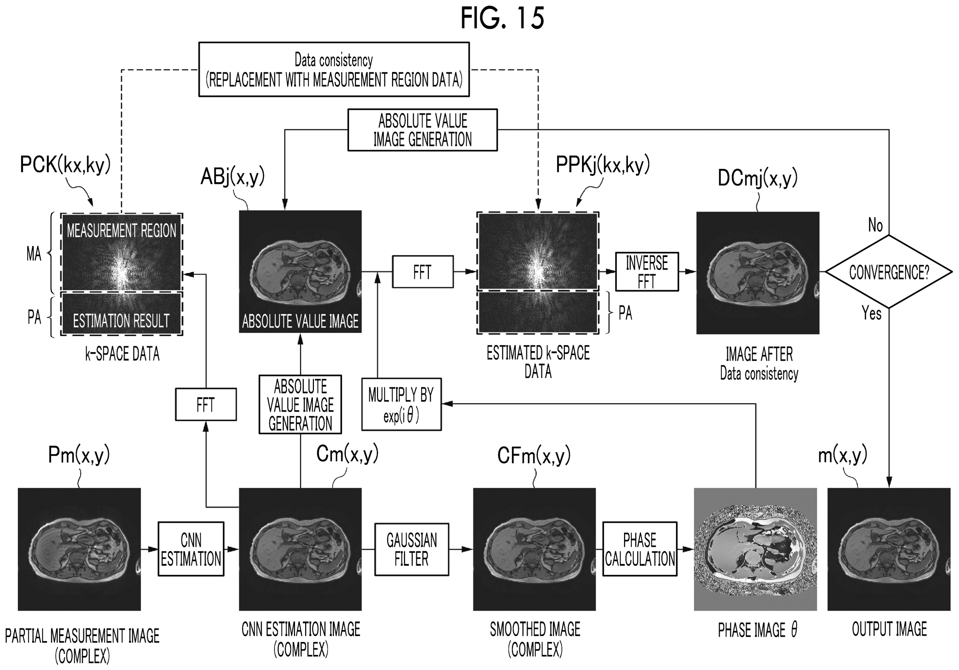

Alternatively, the data replacement unit 238 performs processing of retaining the data of the estimation region that is the estimation result of the unmeasured region UA in the estimated k-space data generated by the Fourier transform unit 236, and replacing the data of the measurement region MA with the data corresponding to the measurement region in the k-space data generated by performing a Fourier transform on the estimation image Cm(x, y). The image processing method in this case will be described later with reference to FIG. 15.

The convergence determination unit 240 determines whether or not the estimation data of the estimation region PA has converged. The convergence determination unit 240 may include, for example, a reconstruction unit 244 and an absolute value image generation unit 246, generate the absolute value image by performing the image reconstruction and the absolute value image generation processing on the estimated k-space data PPKj(kx, ky), evaluate a change amount (difference) of the absolute value image before and after the iterative processing, and determine that the estimation data of the estimation region PA has converged in a case in which the change amount satisfies a predetermined condition.

The convergence determination condition (iterative processing end condition) may be determined by, for example, an indicator for evaluating a noise level of the absolute value image generated from the estimated k-space data PPKj(kx, ky). Further, the convergence determination unit 240 may determine the convergence by determining the number of times of the iterative processing in advance and determining whether or not the iterative processing is executed for the determined number of times.

In a case in which it is determined that the estimation result has not converged as a result of the determination by the convergence determination unit 240, the absolute value image ABj(x, y) to which the phase correction is applied by the absolute value image generated based on the estimated k-space data PPKj(kx, ky) is updated (j → j + 1), and the processing of estimating the data of the estimation region is repeatedly executed in accordance with the algorithm of the POCS method.

The reconstruction unit 244 and the absolute value image generation unit 246 applied to the convergence determination unit 240 may have the same configuration as the reconstruction unit 224 and the absolute value image generation unit 230, and the absolute value image generated by the absolute value image generation unit 246 may be input to the phase correction unit 232 to execute the estimation of the estimation region PA by the POCS iterative processing.

A configuration may be adopted in which the convergence determination unit 240 does not comprise the reconstruction unit 244 and the absolute value image generation unit 246, and in this case, for example, the estimated k-space data PPKj(kx, ky) in which the data of the measurement region MA is replaced with the measured data by the data replacement unit 238 may be returned to the reconstruction unit 224, the absolute value image may be generated by the reconstruction unit 224 and the absolute value image generation unit 230, and the absolute value image ABj(x, y) may be updated.

In a case in which it is determined that the estimated k-space data PPKj(kx, ky) satisfies the convergence determination condition, the convergence determination unit 240 finishes the iterative processing.

The image output unit 250 is a processing unit that outputs the image reconstructed from the estimated k-space data that is finally obtained and satisfies the convergence determination condition. The output image may be the reconstruction image reconstructed by the reconstruction unit 244, may be the absolute value image generated by the absolute value image generation unit 246, or may be both the reconstruction image and the absolute value image.

Examples of the processing of outputting the image include processing of storing the image data in the image storage unit 256. The image storage unit 256 may be the memory 204, the storage 205, or a combination of the memory 204 and the storage 205. In addition, the image data may be stored on a cloud server or the like. The image output unit 250 records the MR image with the accessory information in the image storage unit 256 in accordance with, for example, the medical image format of DICOM. In this case, the MR image is recorded as a square root of the sum of squares of the complex image.

Another example of the processing of outputting the image is processing of displaying the generated image on the display 208. The image output unit 250 may include a display controller 252. The display controller 252 generates data for display on the display 208.

The image for display stored in the image storage unit 256 is displayed on the display 208 via the display controller 252. The display controller 252 displays the MR image calculated by the image calculation unit 330 and necessary accessory information (for example, information on the imaging conditions or the subject 102) on the display 208, and displays the MR image and the like recorded in the memory 204 on the display 208.

Flow of Image Processing Method

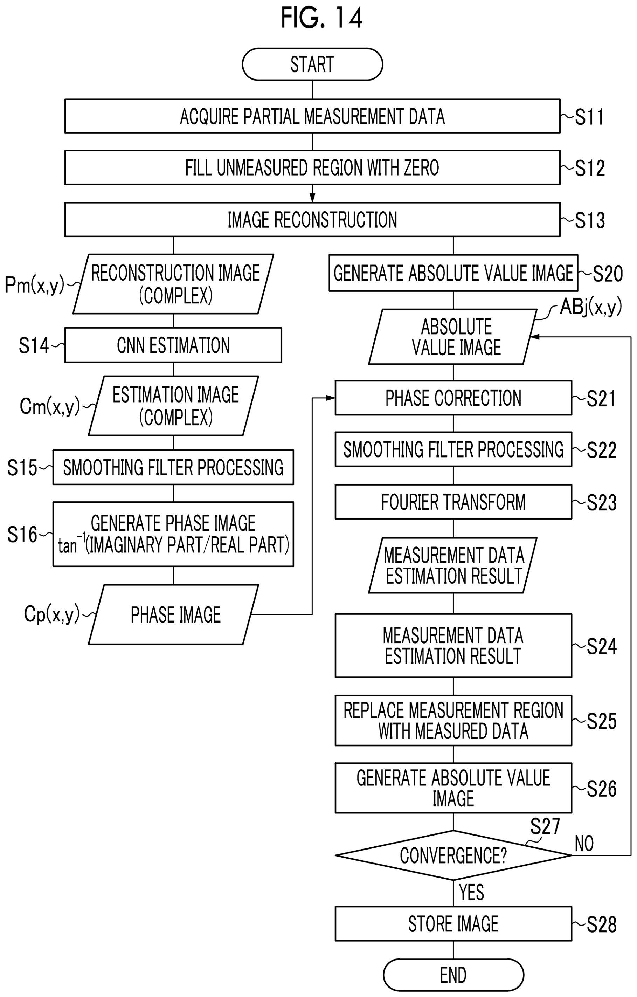

FIG. 14 is a flowchart illustrating steps of the image processing method executed by the image processing apparatus 220 according to the first embodiment.

In step S11, the processor 202 acquires the partial measurement data PK(kx, ky).

In step S12, the processor 202 performs the zero-filling processing of filling the unmeasured region UA with the zero data to obtain the partial measurement data PKze(kx, ky) having the same size as the matrix size of the k-space.

In step S13, the processor 202 performs the image reconstruction processing including an inverse Fourier transform on the partial measurement data in which the unmeasured region is zero-filled to generate the reconstruction image.

In step S14, the processor 202 performs the CNN estimation of inputting the reconstruction image Pm(x, y) generated by the image reconstruction processing to the trained model to obtain the output of the estimation image Cm(x, y) by the trained model.

In step S15, the processor 202 performs the smoothing filter processing on the estimation image Cm(x, y) obtained as the estimation result by the CNN estimation.

In step S16, the processor 202 performs the phase image generation processing based on the filter-processed estimation image CFm(x, y) to generate the phase image Cp(x, y).

In addition, the processor 202 proceeds to step S20 after step S13 and generates the absolute value image ABj(x, y) from the reconstruction image.

In step S21, the processor 202 performs the phase correction by multiplying the absolute value image ABj(x, y) by exp(i·Cp(x, y)) of the phase image Cp(x, y).

In step S22, the processor 202 performs the smoothing filter processing on the corrected image subjected to the phase correction.

In step S23, the processor 202 performs a Fourier transform on the corrected image subjected to the smoothing filter processing to obtain the estimated k-space data as the estimation result of the measurement data corresponding to the filter-processed corrected image.

In step S24, the processor 202 replaces the data of the measurement region in the estimated k-space data obtained in step S23 with the measured data. As a result, the estimated k-space data in which the partial measurement data PK(kx, ky) and the estimation data of the estimation region PA are combined (synthesized) is obtained.

In step S25, the processor 202 performs the image reconstruction by performing an inverse Fourier transform on the estimated k-space data generated in step S24.

In step S26, the processor 202 generates the absolute value image from the reconstruction image obtained by the processing of step S25.

In step S27, the processor 202 determines whether or not the estimation data of the estimation region PA has converged. The processor 202 may evaluate, for example, a difference between the absolute value image ABj+1(x, y) obtained in step S26 and the absolute value image ABj(x, y) before the phase correction in step S21, and determine that the estimation data of the estimation region PA has converged in a case in which the amount of the difference satisfies a predetermined condition. In addition, the processor 202 may evaluate, for example, a noise level of the absolute value image ABj+1(x, y) obtained in step S26, and determine that the estimation data of the estimation region PA has converged in a case in which the noise level satisfies a predetermined condition. An artificial intelligence (AI) model trained through a machine learning algorithm may be used for the convergence determination processing based on the evaluation of the noise level.

In a case in which the determination result in step S27 is "No", the processor 202 returns to step S21, updates the absolute value image ABj(x, y) to the latest absolute value image obtained from step S26, and repeats the processing of steps S21 to S27 (POCS iterative processing).

In a case in which the determination result in step S27 is "Yes", the processor 202 proceeds to step S28 after exiting the POCS iterative processing.

In step S28, the processor 202 stores the image such as the absolute value image and/or the complex image, which is generated by the image reconstruction processing from the estimated k-space data that is finally obtained, in the image storage unit 256. Further, the processor 202 can display the image stored in the image storage unit 256 on the display 208.

After step S28, the processor 202 ends the flowchart of FIG. 14.

Example in Case in which Measurement Region Data of k-Space Data of CNN Estimation Image is Used as Measurement Region Data of Estimated k-Space Data

FIG. 15 is a diagram illustrating an outline of a modification example of the image processing method illustrated in FIG. 12. In FIG. 15, the same or similar elements as those illustrated in FIG. 12 are denoted by the same reference numerals. The image processing method is not limited to the image processing method illustrated in FIG. 12, and the image processing method illustrated in FIG. 15 may be executed.

In the image processing method illustrated in FIG. 15, the processor 202 generates the absolute value image ABj(x, y) by performing the absolute value image generation on the estimation image Cm(x, y) obtained by the CNN estimation method. In addition, the processor 202 generates k-space data PCK(kx, ky) by performing a Fourier transform on the estimation image Cm(x, y), uses data (measurement region data) corresponding to the measurement region MA in the k-space data PCK(kx, ky) as the measurement region data of the estimated k-space data PPKj(kx, ky), and maintains the consistency of the measurement region data of the estimated k-space data PPKj(kx, ky) generated by the POCS iterative processing.

As described in FIGS. 12 and 13, the partial measurement image input to the trained CNN of the CNN estimation unit 226 may be the reconstruction image Pm(x, y) reconstructed from the partial measurement data PKze(kx, ky). In FIG. 15, the generation process of the partial measurement image (Pm(x, y)) that is the input image is not illustrated.

The processor 202 performs the smoothing processing using a Gaussian filter on the estimation image Cm(x, y) to generate the smoothed estimation image CFm(x, y). The Gaussian filter is an example of the smoothing filter. The processor 202 performs the phase calculation from the estimation image CFm(x, y) that is the smoothed image to generate the phase image θ. The phase image θ corresponds to the phase image Cp(x, y) of FIG. 12 (θ = Cp(x, y)).

The processor 202 performs the phase correction of multiplying the absolute value image ABj(x, y) generated from the estimation image Cm(x, y) by exp(iθ), and performs a Fourier transform on the image after the phase correction to generate the estimated k-space data. As described in FIG. 12, the estimated k-space data may be generated by performing a Fourier transform after performing the smoothing filter processing on the phase-corrected image.

The processor 202 retains the data of the estimation region PA that is the estimation result of the unmeasured region UA in the estimated k-space data, and replaces the data of the measurement region MA with the data (measurement region data) corresponding to the measurement region MA in the k-space data PCK(kx, ky) of the estimation image Cm(x, y) (data consistency). As a result, the estimated k-space data PPKj(kx, ky) in which the estimation data of the unmeasured region UA and the measurement region data of the k-space data PCK(kx, ky) are combined is generated.

The processor 202 determines whether or not the estimation data of the unmeasured region UA has converged based on the reconstruction image DCmj(x, y) obtained by performing an inverse Fourier transform on the estimated k-space data PPKj(kx, ky). In a case in which it is determined that the estimation data has not converged (in a case in which the determination result is "No"), the processor 202 performs the absolute value image generation on the reconstruction image DCmj(x, y), newly generates the absolute value image, and updates the absolute value image ABj(x, y). The processor 202 executes the iterative processing until the convergence determination condition is satisfied. In a case in which it is determined that the estimation result of the unmeasured region UA has converged (in a case in which the determination result is "Yes"), the processor 202 ends the iterative processing and generates an output image m(x, y) from the finally obtained estimated k-space data PPKj(kx, ky).

Application of Smoothing Filter to CNN Estimation Image

In the image processing method according to the present embodiment, in a case of obtaining the phase image from the CNN estimation image obtained by the CNN estimation method, the smoothing filter is applied to the CNN estimation image.

The characteristics of the finally obtained image may change depending on the filter strength of the smoothing filter. In a case in which the filter strength of the smoothing filter is compared between a case in which the filter strength is weak and a case in which the filter strength is strong, in a case in which the filter strength is weak, the final image is close to the CNN estimation image. Therefore, the effect of suppressing the striped noise may be slightly decreased, and the striped noise may remain slightly, but an image with few artifacts and a high SNR can be obtained.

On the other hand, in a case in which the filter strength is strong, the final image is close to the estimation image by the POCS method. Therefore, the effect of suppressing the striped noise is increased. On the other hand, the image may have many artifacts and a low SNR.

By adjusting the strength of the smoothing filter applied after the CNN estimation, it is possible to control the balance between the striped noise, the artifacts, and the SNR. Further, the filter processing on the CNN estimation image is not limited to the smoothing filter, and the edge enhancement filter may be used in combination.

Example of Method of Setting Filter Strength

As a method of setting the filter strength of the smoothing filter applied to the CNN estimation image, for example, the following methods may be used.

[Method 1] The development side may visually evaluate the MR image to determine one filter strength that will enhance the effect of suppressing the striped noise and reduce the artifacts. In addition, the strength of the filter to be used may be set to be different depending on the imaging target part (examination part).

[Method 2] The image processing apparatus 220 may be configured such that the user can freely set the filter strength via the user interface to adjust the effect of suppressing the striped noise, the artifacts, and the SNR.

[Method 3] The issue that the noise appears in a stripe shape in the MR image occurs in a case in which the noise is large. Therefore, in the image processing apparatus 220, the filter strength of the smoothing filter may be prepared in a plurality of stages, and the processor 202 may be configured to calculate the SNR of the MR image and automatically set an appropriate filter strength from among the plurality of stages of the filter strength in accordance with the calculation result of the SNR of the MR image.

For example, the filter strength may be prepared in three stages of weak, medium, and strong, and the processor 202 may calculate the SNR of the MR image and automatically set the filter strength in accordance with the comparison result between the SNR of the MR image calculated by the processor 202 and predetermined determination reference values, which are SNR1 and SNR2.

That is, in a case in which it is assumed that SNR1 < SNR2, the case is classified into three patterns of a case in which SNR < SNR1, a case in which SNR1 ≤ SNR ≤ SNR2, and a case in which SNR2 < SNR, and the filter strength is set to "strong" in a case in which SNR < SNR1, the filter strength is set to "medium" in a case in which SNR1 ≤ SNR ≤ SNR2, and the filter strength is set to "weak" in a case in which SNR2 < SNR.

[Method 4] The issue that the noise appears in a stripe shape in the MR image occurs in a case in which the unmeasured proportion with respect to the full measurement data is large. Therefore, in the image processing apparatus 220, the filter strength of the smoothing filter may be prepared in a plurality of stages, and the processor 202 may be configured to automatically set an appropriate filter strength from among the plurality of stages of the filter strength in accordance with the unmeasured proportion of the partial measurement data.

For example, the filter strength may be prepared in three stages of weak, medium, and strong, and the processor 202 may acquire the unmeasured proportion R and automatically set the filter strength in accordance with the comparison result between the unmeasured proportion R and predetermined determination reference values, which are R1 and R2.

That is, in a case in which it is assumed that R1 < R2, the case is classified into three patterns of a case in which R < R1, a case in which R1 ≤ R ≤ R2, and a case in which R2 < R, and the filter strength is set to "weak" in a case in which R < R1, the filter strength is set to "medium" in a case in which R1 ≤ R ≤ R2, and the filter strength is set to "strong" in a case in which R2 < R.

[Method 5] The likelihood of the occurrence of the artifacts varies depending on the pulse sequence during the imaging in which the measurement data is collected. Therefore, in the image processing apparatus 220, the filter strength of the smoothing filter may be prepared in a plurality of stages, and the processor 202 may be configured to automatically set an appropriate filter strength from among the plurality of stages of the filter strength in accordance with the pulse sequence.

For example, the strength of the filter is prepared in two stages of "weak" and "strong", the filter strength is set to "weak" for the sequence in which the artifacts are likely to occur, and the filter strength is set to "strong" for the sequence in which the artifacts are unlikely to occur. Examples of the sequence in which the artifacts are likely to occur include a gradient echo method and an echo planar imaging (EPI) method, and examples of the sequence in which the artifacts are unlikely to occur include a spin echo method and a fast spin echo method.

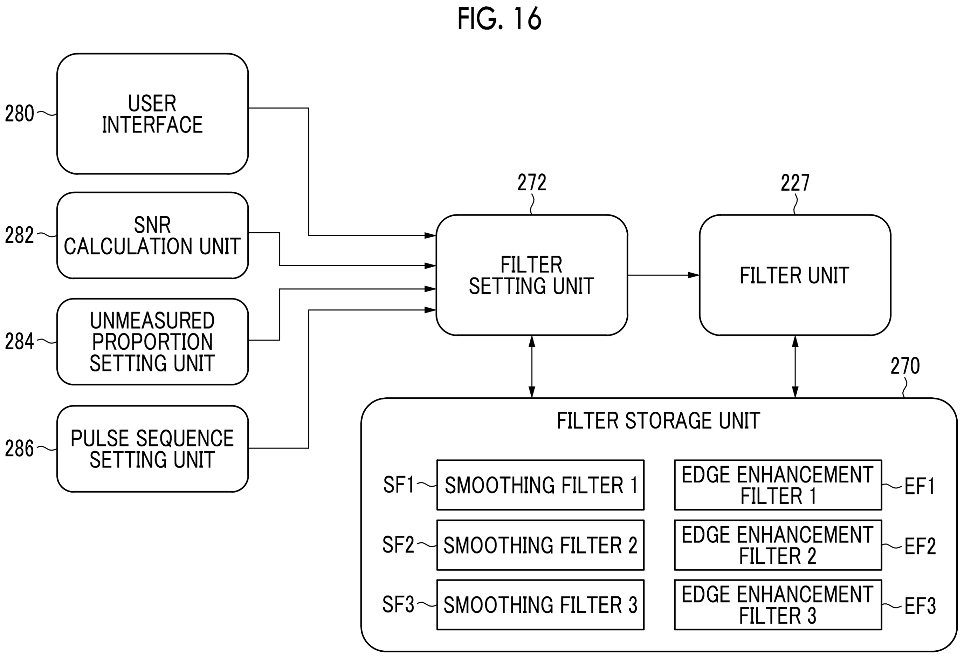

FIG. 16 is a block diagram illustrating a functional configuration for achieving a function of setting the filter strength in the image processing apparatus 220. As illustrated in FIG. 16, the image processing apparatus 220 comprises a filter storage unit 270 and a filter setting unit 272. The filter storage unit 270 is a storage region in which a plurality of types of filters having different filter strength are stored. In FIG. 16, as a specific example of the plurality of types of filters, an example is illustrated in which three types of smoothing filters SF1, SF2, and SF3 and three types of edge enhancement filters EF1, EF2, and EF3 are prepared, but the type and the number of the filters are not particularly limited. The hardware of the filter storage unit 270 may be the memory 204, the storage 205, or a combination of the memory 204 and the storage 205.

The filter setting unit 272 selects the filter to be used in the filter unit 227 from among the filters stored in the filter storage unit 270, and sets the selected filter in the filter unit 227. The image processing apparatus 220 may receive an instruction to select the filter from the operator via a user interface 280, or may receive information such as filter parameters for designating a desired filter. The user interface 280 may include the display 208 and the operation unit 210.

The image processing apparatus 220 may comprise at least one of an SNR calculation unit 282, an unmeasured proportion setting unit 284, or a pulse sequence setting unit 286. The SNR calculation unit 282 calculates the SNR of the MR image generated based on the partial measurement data. The filter setting unit 272 may select the filter to be applied to the filter unit 227 in accordance with the SNR calculated by the SNR calculation unit 282.

The filter setting unit 272 may change the filter to be applied to the filter unit 227 based on the SNR of the MR image generated by applying the filter related to the initial setting, and regenerate the MR image by using the changed filter.

The unmeasured proportion setting unit 284 is a processing unit that sets the unmeasured proportion in a case in which the asymmetric sampling of the k-space is performed. The filter setting unit 272 may select the filter to be applied to the filter unit 227 in accordance with the unmeasured proportion set by the unmeasured proportion setting unit 284.

The pulse sequence setting unit 286 is a processing unit that sets the pulse sequence used for the imaging. The filter setting unit 272 may select the filter to be applied to the filter unit 227 in accordance with the pulse sequence set by the pulse sequence setting unit 286.

The user interface 280 provides a setting screen of the imaging parameters, and the operator can perform the input of designating the unmeasured proportion and the pulse sequence through the setting screen. In addition, the same configuration as the filter setting unit 272 illustrated in FIG. 16 may be applied to the filter unit 234 (see FIG. 13), and the filter type and the filter strength of the filter processing to be performed on the image after the phase correction by the phase correction unit 232 may be adjusted.

Effect of First Embodiment

With the MRI apparatus 10 in which the image processing apparatus 220 according to the first embodiment is implemented, the data of the unmeasured region is estimated by applying the phase image Cp(x, y) having high accuracy, which is generated from the estimation image Cm(x, y) estimated by the CNN estimation method, to the phase correction of the POCS method, so that the MR image in which the occurrence of the striped noise is reduced and the artifacts are reduced can be provided.

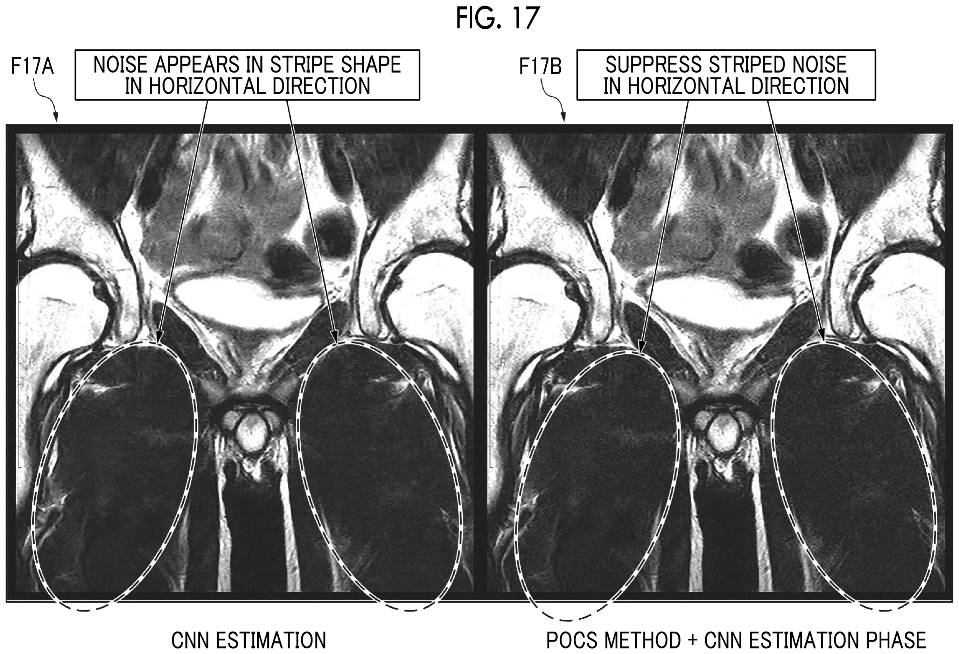

FIG. 17 is a diagram illustrating an example of the effect of reducing the striped noise according to the first embodiment. An MR image F17A illustrated on the left side of FIG. 17 is an image obtained by the CNN estimation method according to a comparative example. An MR image F17B illustrated on the right side of FIG. 17 is an image obtained by the image processing method according to the embodiment of the present disclosure. FIG. 17 illustrates an example of a pelvic T2-weighted image in which the unmeasured proportion is 45%. In a case in which the unmeasured proportion is set to 0% in the full sampling (full measurement), the imaging time is, for example, 2 minutes and 28 seconds, whereas the imaging time can be shortened to 1 minute and 10 seconds in a case in which the unmeasured proportion is set to 45%.

In the MR image F17A generated by the CNN estimation method according to the comparative example, the noise appears in a stripe shape in the horizontal direction in a region surrounded by a broken line ellipse, whereas in the MR image F17B generated by the image processing method according to the present embodiment, the striped noise in the horizontal direction is less visible.

Second Embodiment

Issue: Resolution Degradation in CNN Estimation Image

In the method using the CNN described in US2022/0198725A, the data of the unmeasured region is estimated from the data of the measurement region, but it is difficult to completely restore even the radio frequency component, and the resolution is degraded. In addition, in a case in which the edge is simply enhanced using the edge enhancement filter on the estimation image of the CNN, the noise of the measurement region is also increased.

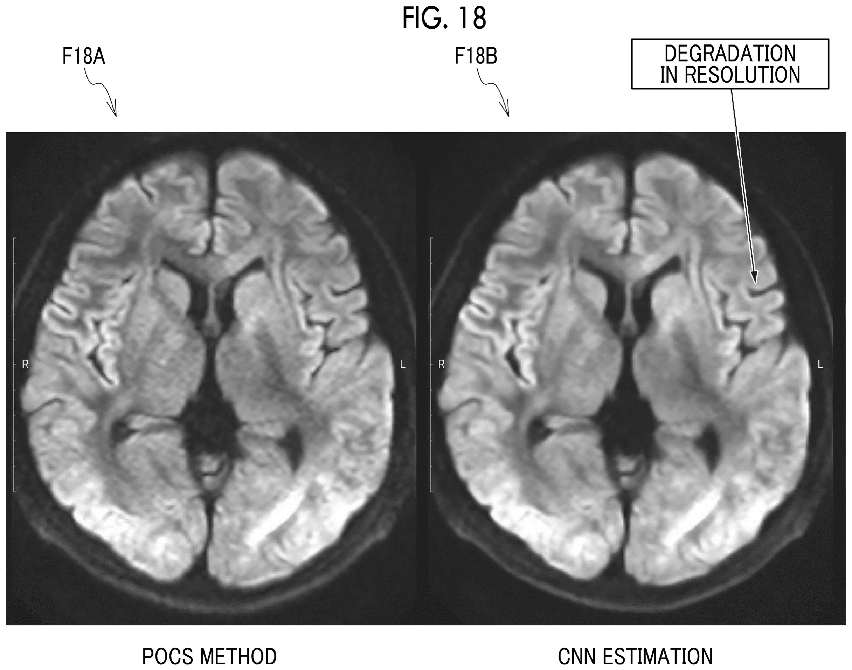

FIG. 18 is a diagram illustrating the degradation in resolution of the estimation image by the CNN estimation method. FIG. 18 illustrates an example of an MR image F18A in a case in which the unmeasured region is estimated by the POCS method and an MR image F18B in a case in which the unmeasured region is estimated by the CNN. The MR image F18A and the MR image F18B are diffusion-weighted head images in which the unmeasured proportion is 40%.

As illustrated in FIG. 18, the resolution of the MR image F18B in a case in which the unmeasured region is estimated by the CNN is lower than that of the MR image F18A generated by applying the POCS method. The degradation in resolution here may be understood as the degradation in sharpness of the image.

Outline of Image Processing Method According to Second Embodiment

In the image processing apparatus 220 according to a second embodiment, the processing of improving the resolution is added to the CNN estimation image estimated by the CNN estimation unit. Other processing may be the same as the processing of the first embodiment.

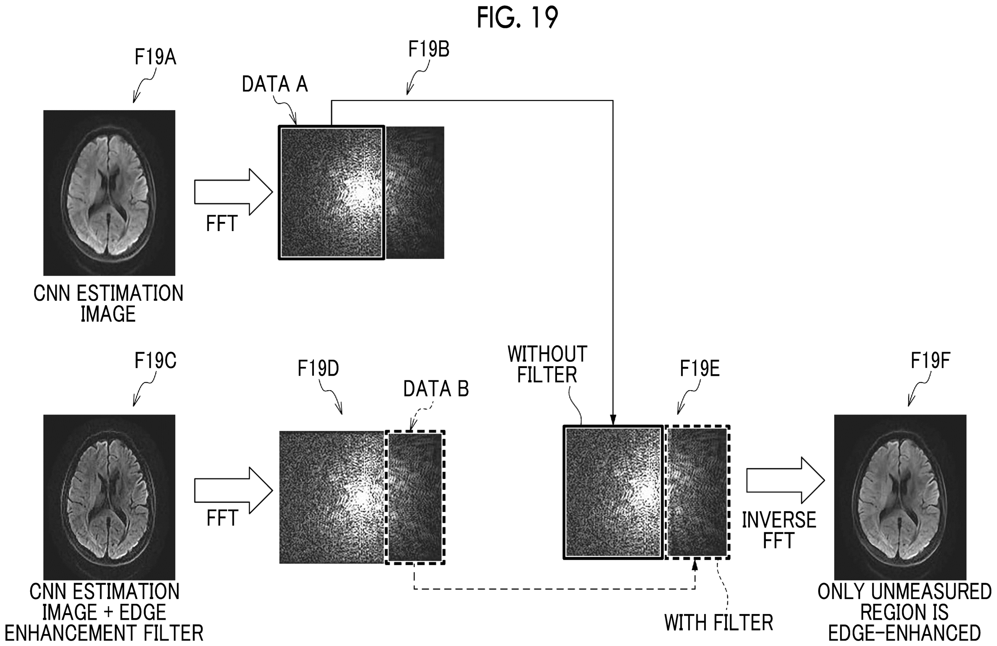

FIG. 19 is a diagram illustrating an outline of a method of improving the resolution of the CNN estimation image in the image processing method according to the second embodiment.

First, the processor 202 obtains data A of the measurement region by performing a Fourier transform on a CNN estimation image F19A output from the CNN estimation unit 226 to obtain k-space data F19B. The CNN estimation image F19A is an example of an "estimation image" in the present disclosure, and the data A is an example of "first measurement region data" in the present disclosure.

Next, the processor 202 performs the edge enhancement filter processing on the CNN estimation image F19A to generate an edge enhancement estimation image F19C that is the edge-enhanced estimation image. The processor 202 obtains data B of the unmeasured region from k-space data F19D by performing a Fourier transform on the edge enhancement estimation image F19C to obtain k-space data F19D. The edge enhancement estimation image F19C is an example of a "first edge enhancement estimation image" in the present disclosure, and the data B is an example of "first unmeasured region data" in the present disclosure.

The processor 202 generates k-space data F19E by combining the data A of the measurement region to which the edge enhancement filter is not applied and the data B of the unmeasured region to which the edge enhancement filter is applied. The processor 202 generates an estimation image F19F in which only the unmeasured region is edge-enhanced by performing an inverse Fourier transform on the combined k-space data F19E. The estimation image F19F is an example of a "second edge enhancement estimation image" in the present disclosure.

The strength of the edge enhancement may be adjusted to the strength at which the average value of the absolute values of the estimation region in the k-space and the average value of the absolute values of the measurement region are at the same level. In this way, the estimation image F19F generated in this way can be an image in which the resolution is improved while the increase in noise is suppressed as compared with the original CNN estimation image F19A and the edge enhancement estimation image F19C.

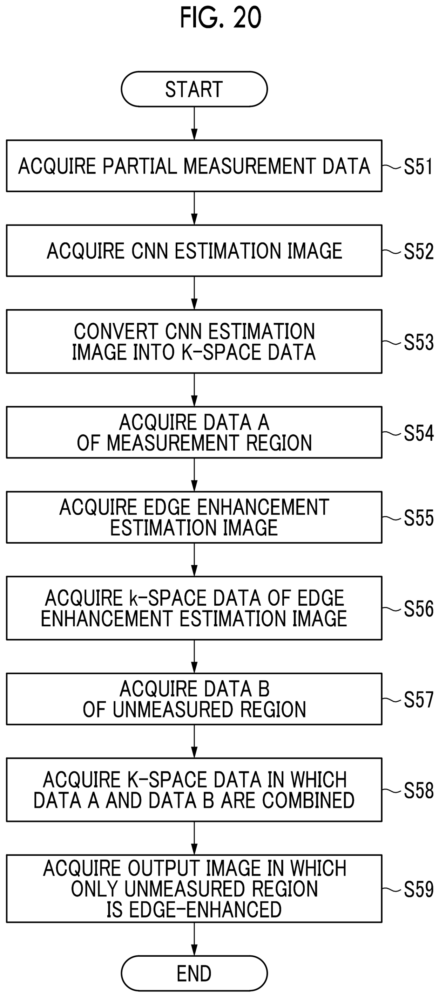

FIG. 20 is a flowchart illustrating steps of the image processing method according to the second embodiment.

In step S51, the processor 202 acquires the partial measurement data. The partial measurement data is data measured in the asymmetrical measurement region in the k-space in the measurement unit 100. The unmeasured direction and the unmeasured proportion in the k-space may be determined as appropriate.

In step S52, the processor 202 acquires the CNN estimation image from the partial measurement data acquired in step S51. The term "acquire" includes the concept of "generate". That is, the description "acquire" includes the concept of acquisition by generation.

The CNN estimation image may be an estimation image output from the trained CNN in a case in which the reconstruction image reconstructed from the k-space data consisting of the partial measurement data and the zero data filling the unmeasured region is input to the trained model.

The processor 202 generates the k-space data by filling the unmeasured region other than the measurement region in which the partial measurement data fills the k-space with the zero data, and generates the reconstruction image of the real space by performing an inverse Fourier transform on the k-space data. The processor 202 inputs the reconstruction image generated based on the partial measurement data to the trained CNN to obtain the CNN estimation image.

In step S53, the processor 202 performs a Fourier transform on the CNN estimation image acquired in step S52 to convert the CNN estimation image into the k-space data.

In step S54, the processor 202 acquires the data of the measurement region in the k-space data acquired in step S53, as the data A.

In step S55, the processor 202 performs the edge enhancement processing by applying the edge enhancement filter to the CNN estimation image acquired in step S52 to acquire the edge enhancement estimation image.

In step S56, the processor 202 performs a Fourier transform on the edge enhancement estimation image acquired in step S55 to convert the edge enhancement estimation image into the k-space data.

In step S57, the processor 202 acquires the data of the unmeasured region in the k-space data acquired in step S56, as the data B.

In step S58, the processor 202 acquires the k-space data obtained by combining the data A acquired in step S54 and the data B acquired in step S57.

In step S59, the processor 202 acquires the MR image of the real space that is the output image in which only the data of the unmeasured region is edge-enhanced by performing an inverse Fourier transform on the k-space data acquired in step S58. In the MR image acquired in step S59, the noise of the data of the measurement region is suppressed, the edge of the data of the unmeasured region is enhanced, and the resolution is improved.

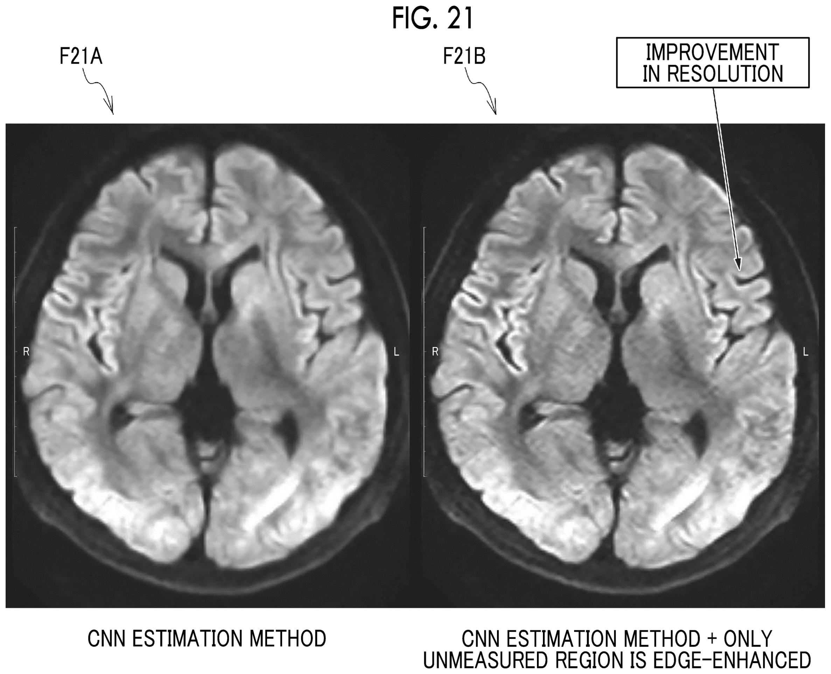

FIG. 21 is an example of an MR image showing the improvement in the resolution. An MR image F21A illustrated on the left side of FIG. 21 is a CNN estimation image according to a comparative example. An MR image F21B illustrated on the right side of FIG. 21 is an estimation image generated by the image processing method according to the second embodiment, and is an image in which only the data of the unmeasured region is subjected to the edge enhancement processing. Each of the MR image F21A and the MR image F21B is an example of a diffusion-weighted head image in which the unmeasured proportion of the asymmetric sampling is 40%. As illustrated in FIG. 21, it can be seen that the MR image F21B generated by the image processing method according to the second embodiment has improved resolution while suppressing the increase in noise as compared with the MR image F21A according to the comparative example.

In the image processing apparatus 220 according to the second embodiment, as described with reference to FIGS. 19 and 20, the phase image is generated from the estimation image F19F in which the edge enhancement processing is applied only to the unmeasured region, and the phase correction is performed. Other configurations may be the same as the configurations of the first embodiment.

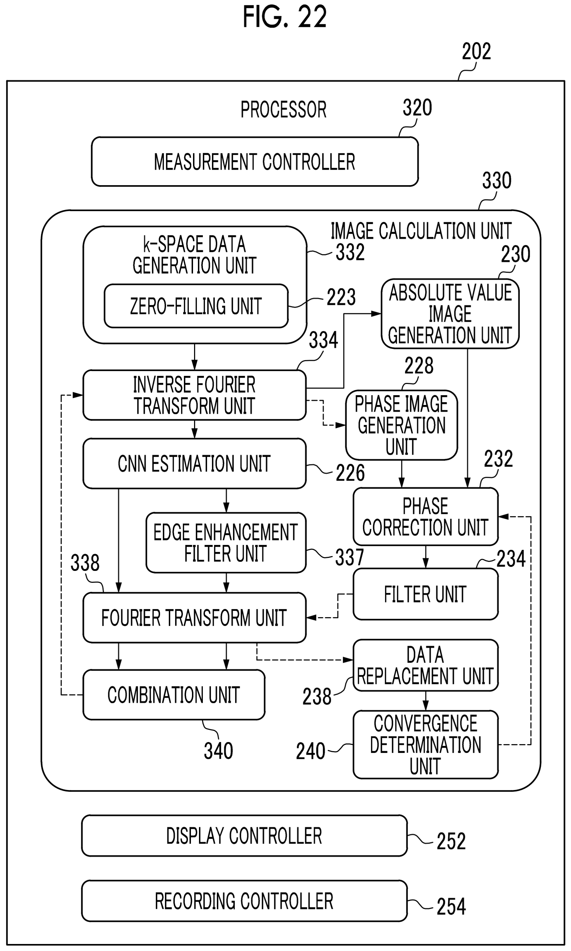

FIG. 22 is a block diagram illustrating a functional configuration of the processor implemented in the control device 200 of the MRI apparatus 10 according to the second embodiment. In the configuration illustrated in FIG. 22, the same or similar elements as those illustrated in FIG. 13 are denoted by the same reference numerals, and duplicate descriptions will be omitted as appropriate.

The processor 202 executes various programs including the trained model stored in the memory 204 to function as a measurement controller 320, an image calculation unit 330, the display controller 252, and a recording controller 254. The measurement controller 320 transmits a predetermined pulse sequence, the imaging conditions (imaging parameters) designated by the operator, and the like to the sequencer 118 (see FIG. 1) of the measurement unit 100, and controls the measurement unit 100 via the sequencer 118.

The image calculation unit 330 includes a k-space data generation unit 332, an inverse Fourier transform unit 334, the CNN estimation unit 226, an edge enhancement filter unit 337, a Fourier transform unit 338, a combination unit 340, and the like. In addition, the image calculation unit 330 includes the phase image generation unit 228, the absolute value image generation unit 230, the phase correction unit 232, the filter unit 234, the data replacement unit 238, and the convergence determination unit 240 as in FIG. 13.

The k-space data generation unit 332 stores the measurement data that is the digital data of the real part and the imaginary part obtained from the measurement unit 100, and is sequentially collected from the echo signal along the k-trajectory, in the matrix of the k-space. For example, in a case in which the matrix size of the number of pixels of the FOV is set to 256 pixels $\times$ 256 pixels, the k-space also has a size of $256 \times 256$, but the data of the asymmetrical unmeasured region by the half-scan measurement or the half-echo measurement in the entire region of the k-space is not collected, and the k-space data generation unit 332 acquires the partial measurement data of the measurement region excluding the unmeasured region arbitrarily set for the k-space, stores the partial measurement data in the space of the matrix of the k-space, and fills the unmeasured region with the zero data to generate the k-space data of the designated matrix size. The k-space data generation unit 332 may include the zero-filling unit 223 that performs the processing of filling the unmeasured region with the zero data.

It goes without saying that, in a case in which the k-space data is acquired by using the matrix in which the entire region of the matrix of the k-space before storing the measurement data is filled with the zero data as the initial value and the zero data in the matrix is sequentially replaced with the data collected by the measurement, the processing of filling the unmeasured region with the zero data is not required after acquiring the measurement data.

The inverse Fourier transform unit 334 performs an inverse Fourier transform (inverse FFT) in the k-space data to generate the image in the real space. The inverse Fourier transform unit 334 corresponds to the reconstruction unit 224 in FIG. 13, and generates the reconstruction image from the k-space data generated by the k-space data generation unit 332.

The CNN estimation unit 226 estimates the full measurement image from the partial measurement image using the trained model, and outputs the estimation image as the estimation result. The edge enhancement filter unit 337 performs the edge enhancement processing by applying the edge enhancement filter to the estimation image output from the CNN estimation unit 226. The edge enhancement filter is, for example, unsharp mask processing. The edge enhancement filter unit 337 can adjust the strength of the edge enhancement by continuously or discretely adjusting the strength of the unsharp mask processing, for example.

The edge enhancement filter unit 337 may acquire the strength of the edge enhancement in the edge enhancement filter processing based on the average value of the absolute values of the data of the measurement region that is symmetric to the unmeasured region of the k-space in the data A of the measurement region of the k-space and the average value of the absolute values of the data B of the unmeasured region. For example, the edge enhancement filter unit 337 may determine the strength of the edge enhancement to the strength at which the average value of the absolute values of the data of the measurement region that is symmetric to the unmeasured region and the average value of the absolute values of the data B are at the same level. The same level is preferably within $\pm 5\%$, more preferably within $\pm 3\%$, and still more preferably within $\pm 1\%$.

In addition, the edge enhancement filter unit 337 may receive the input of the strength from the operator and perform the edge enhancement filter processing with the received strength. The processor 202 may display the output image and a slider bar for adjusting the strength of the edge enhancement filter processing on the display 208. In this case, the strength is determined in accordance with the position of the slider of the slider bar.

As a result, the operator can change the position of the slider of the slider bar while visually recognizing the output image to adjust the strength of the edge enhancement filter processing to appropriate strength.

The Fourier transform unit 338 performs a Fourier transform (FFT) on the image in the real space to generate the k-space data. The Fourier transform unit 338 generates first estimated k-space data by performing a Fourier transform on the estimation image output from the CNN estimation unit 226. In addition, the Fourier transform unit 338 generates second estimated k-space data by performing a Fourier transform on the edge enhancement estimation image that is the estimation image edge-enhanced by the edge enhancement filter unit 337. The Fourier transform unit 338 functions as the Fourier transform unit 236 in FIG. 13.

The combination unit 340 extracts the data A corresponding to the measurement region from the first estimated k-space data, extracts the data B corresponding to the unmeasured region from the second k-space data, and combines the data A and the data B to generate combined k-space data. The combined k-space data generated by the combination unit 340 is subjected to an inverse Fourier transform by the inverse Fourier transform unit 334 to obtain a combined reconstruction image.

The phase image generation unit 228 generates the phase image from the combined reconstruction image reconstructed from the combined k-space data combined in the combination unit 340. As in the first embodiment, the phase image may be generated from the image in which the smoothing filter is applied to the combined reconstruction image. The image processing method of applying the phase image to the algorithm of the POCS method to estimate the data of the unmeasured region is the same as the image processing method of the first embodiment.

The recording controller 254 records the MR image with the accessory information in the memory 204 in, for example, the medical image format of DICOM. The MR image in this case is recorded as a sum-of-squares image of the complex image. The recording controller 254 may be included in the image output unit 250 of FIG. 13.

Effect of Second Embodiment

According to the second embodiment, the MR image having further improved image quality as compared with the first embodiment can be obtained.

Third Embodiment: Improvement of Boundary Processing in Combination Unit

In the second embodiment, the data A and the data B obtained by performing a Fourier transform on the CNN estimation image F19A are simply connected by the combination unit 340 to generate the k-space data, but in a third embodiment, a combination method of smoothly connecting the data of the measurement region and the data of the estimation region to which the edge enhancement is applied is applied.

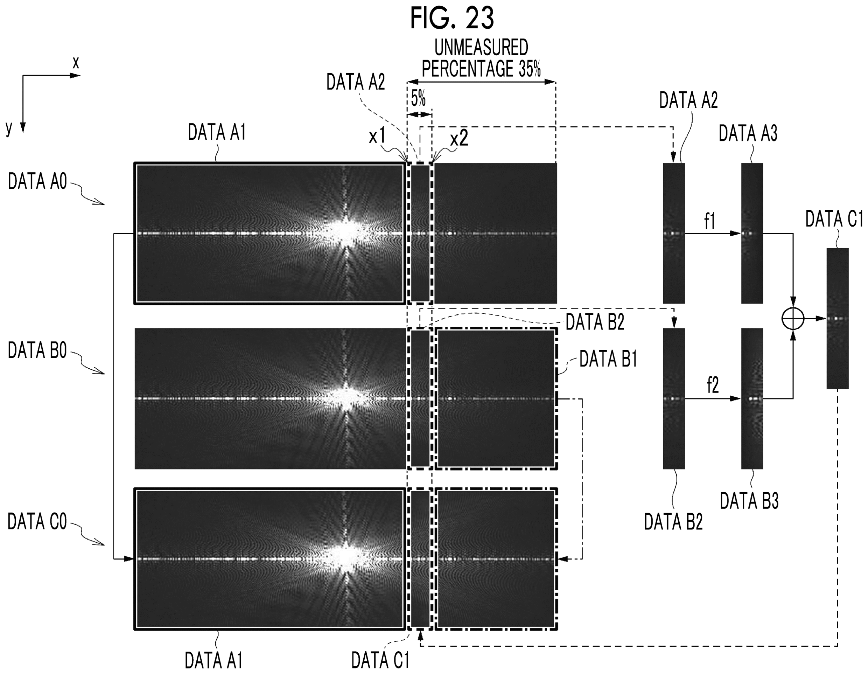

FIG. 23 is a diagram illustrating an outline of a method of smoothly connecting data of the measurement region and data of the estimation region to which the edge enhancement is applied in the image processing method according to the third embodiment. Here, as an example, a case will be described in which the CNN estimation image is generated from the partial measurement data in which the unmeasured direction is the x direction and the unmeasured percentage is 35%.

As illustrated in the upper part of FIG. 23, k-space data obtained by performing a Fourier transform (FFT) on the CNN estimation image having an unmeasured percentage of 35% is referred to as data A0. Data corresponding to the measurement region in the data A0 is referred to as data A1. Further, a boundary between the measurement region and the unmeasured region in the data A0 is denoted by x1, a position separated by 5% of the data size in the x direction (unmeasured direction) from the boundary x1 is denoted by x2, and the processor 202 cuts out data A2 of an adjacent region that is a region from the position x1 to the position x2 in the data A0. The x direction in the k-space means the direction of the kx axis. A width of the adjacent region in the x direction is not limited to 5% of the data size, and can be determined as appropriate. Data of the unmeasured region other than the data A1 in the data A0 illustrated in FIG. 22 is an example of "second unmeasured region data" in the present disclosure, and the data A2 is an example of "first adjacent region data" in the present disclosure.

In addition, as illustrated in the middle part of FIG. 23, k-space data obtained by performing a Fourier transform (FFT) on the image obtained by performing the edge enhancement processing on the CNN estimation image having an unmeasured percentage of 35% is referred to as data B0. Similarly to the data A2, the processor 202 cuts out data B2 of the adjacent region from the position x1 to the position x2 in the data B0. Data other than the data B2 in the data corresponding to the unmeasured region in the data B0 is referred to as data B1. The data B2 is an example of "second adjacent region data" in the present disclosure, and is an example of "first unmeasured region data" in the data B1 and the data B2.

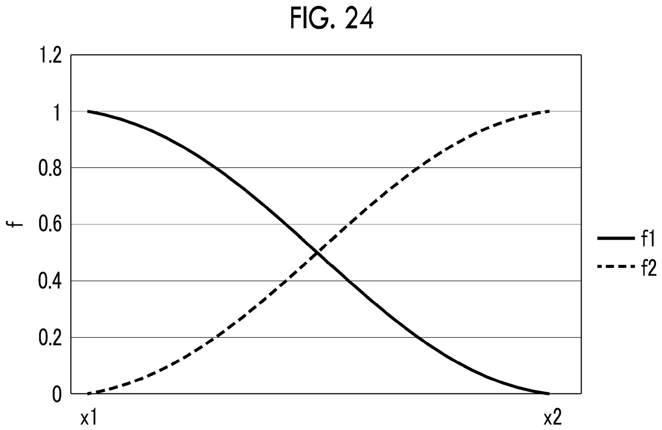

Then, as illustrated in FIG. 24, the processor 202 multiplies the data A2 by a Hanning window function f1 having a value of 1 at the position x1 and a value of 0 at the position x2 to generate data A3. Further, the processor 202 multiplies the data B2 by a Hanning window function f2 having a value of 0 at the position x1 and a value of 1 at the position x2 to generate data B3.

The Hanning window function f1 illustrated in FIG. 24 has a value of "1" at the position x1, the value gradually decreases as approaching the position x2, and the value reaches "0" at the position x2. That is, the Hanning window function f1 is a function that converges from x1 to x2. The Hanning window function f2 illustrated

**EP 4 782 867 A1**

in FIG. 24 has a value of "0" at the position x1, the value gradually increases as approaching the position x2, and the value reaches "1" at the position x2. That is, the Hanning window function f2 is a function that converges from x2 to x1. The Hanning window function f1 illustrated in FIG. 24 is an example of a "first window function" in the present disclosure, and the Hanning window function f2 is an example of a "second window function" in the present disclosure.

The processor 202 adds the data A2 and the data B2 obtained by applying the Hanning window functions f1 and f2 to generate data C1. The data C1 is an example of "third adjacent region data" in the present disclosure.

Then, as illustrated in the lower part of FIG. 23, the processor 202 combines the data A1 cut out from the data A0, the data B1 cut out from the data B0, and the data C1 to generate data C0 of the k-space. The data C0 generated in this way is the k-space data in which the boundaries between the measurement region and the estimation region are smoothly connected.

The combination unit 340 in the image processing apparatus 220 according to the third embodiment performs the combination processing as illustrated in FIGS. 23 and 24. Other configurations may be the same as the configurations of the second embodiment.

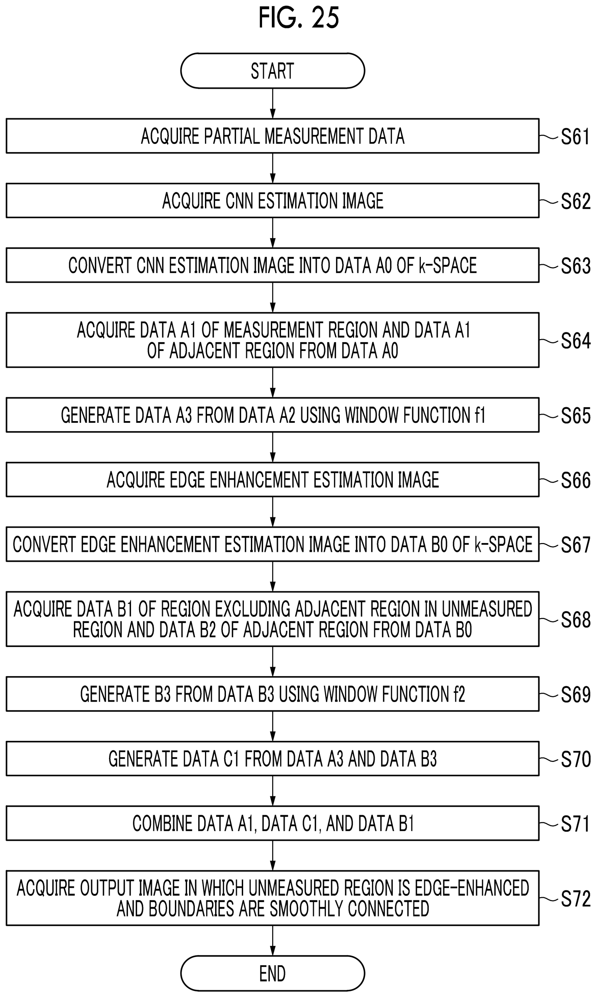

FIG. 25 is a flowchart illustrating steps of the image generation method according to the third embodiment.

The processing of steps S61 and S62 is the same as the processing of steps S51 and S52 illustrated in FIG. 20.

In step S63, the processor 202 performs a Fourier transform (FFT) on the CNN estimation image acquired in step S62 to convert the CNN estimation image into the data A0 of the k-space.

In step S64, the processor 202 acquires the data A1 of the measurement region and the data A2 of the adjacent region from the data A0 of the k-space converted in step S63. Here, the combination unit 340 acquires the entire data of the measurement region in the data A0 of the k-space converted in step S63, as the data A1. In addition, the combination unit 340 acquires the entire data of the adjacent region that is adjacent to the measurement region and that extends a predetermined distance from the measurement region in the data of the unmeasured region from the data A0, as the data A2. As an example of the "predetermined distance", in the third embodiment, a region from the position x1 of the boundary between the measurement region and the unmeasured region to the position x2 separated by 5% of the data size in the x direction is defined as the adjacent region.

In step S65, the processor 202 generates the data A3 in which the weight of the data A2 is gradually decreased as a distance from the measurement region increases. Here, the combination unit 340 multiplies the data A2 by the Hanning window function f1 to generate the data A3.

In step S66, the processor 202 acquires the edge enhancement estimation image by performing the edge enhancement filter processing on the CNN estimation image acquired in step S62.

In step S67, the processor 202 performs a Fourier transform (FFT) on the edge enhancement estimation image acquired in step S66 to convert the edge enhancement estimation image into the data B0 of the k-space.

In step S68, the processor 202 acquires the data B2 of the adjacent region from the data B0 of the k-space converted in step S67. Further, the processor 202 acquires the data B1 of the region other than the adjacent region in the unmeasured region from the data B0. Here, the combination unit 340 acquires the entire data of the adjacent region in the data B0 of the k-space converted in step S67 as the data B2. In addition, the combination unit 340 acquires the entire data of the region other than the adjacent region in the unmeasured region in the data B0 of the k-space as the data B1.

In step S69, the processor 202 generates the data B3 in which the weight of the data B2 is gradually increased as a distance from the measurement region increases. Here, the combination unit 340 multiplies the data B2 by the Hanning window function f2 to generate the data B3.

In step S70, the processor 202 generates the data C1 from the data A3 and the data B3. Here, the combination unit 340 adds the data A3 and the data B3 to generate the data C1.

In step S71, the processor 202 generates the data C0 of the k-space by combining the data A1 acquired in step S64, the data B1 acquired in step S68, and the data C1 generated in step S70. Here, the combination unit 340 fills the measurement region of the k-space with the data A1, fills the adjacent region of the k-space with the data C1, and fills the unmeasured region other than the adjacent region of the k-space with the data B1 to generate the data C0 of the k-space.

In step S72, the processor 202 reconstructs the image of the real space by performing an inverse Fourier transform on the data C0 of the k-space generated in step S71 to acquire the output image. The MR image acquired in this way has improved resolution because the noise of the data A1 of the measurement region is suppressed and the edge of the data of the unmeasured region is enhanced, and the image quality is further improved as compared with the output image of the second embodiment because the MR image is reconstructed from the data C0 in which the data A1 of the measurement region and the estimation data B1 of the unmeasured region are smoothly connected via the data C1 of the adjacent region.

In the image processing apparatus 220 according to the third embodiment, the phase image is generated from the CNN estimation image generated by the method described with reference to FIGS. 23 to 25, and the phase correction is performed. Other configurations may be the same as the configurations of the first embodiment.

Effect of Third Embodiment

According to the third embodiment, it is possible to obtain the MR image having further improved image quality as compared with the first and second embodiments.

Processor

In the embodiments of the present disclosure, each processing is executed by any computer. Further, any computer may execute the processing by a processor, a program, or a combination thereof. Any computer may be a general-purpose computer, a computer for a specific purpose, a system such as a workstation, or other hardware elements capable of executing a program.

The processor may be configured by one or a plurality of pieces of hardware, and the type of hardware is not limited. For example, the processor may be configured by a central processing unit (CPU), a micro processing unit (MPU), a programmable logic device such as a field programmable gate array (FPGA), a dedicated circuit for executing specific processing, such as an application specific integrated circuit (ASIC), or hardware such as a graphics processing unit (GPU) or a neural processing unit (NPU).

The processor includes each unit or each means that executes various types of processing in the present embodiment. Furthermore, the type of hardware may be a combination of different kinds of hardware. In a case in which the plurality of types of hardware are configured to execute one or a plurality of processes of a certain processor, the plurality of types of hardware may be present in devices physically separated from each other or may be present in the same device. Further, in any of the embodiments, the order of each process performed by the processor is not limited to the above-described order, and may be changed as appropriate. The hardware is configured by an electric circuit (circuitry) in which circuit elements, such as semiconductor elements, are combined, or the like.

Further, the present embodiment may be implemented by hardware, software, firmware, microcode, or a combination thereof. Software, firmware, and microcode are configured by a program. The program may be, for example, a group of program modules, and each function thereof may be implemented by a processor configured to execute each function. The program may be a program code or a plurality of code segments stored in one or more non-transitory computer-readable media (for example, a storage medium and other storages). The program may be stored in the plurality of non-transitory computer-readable media existing in devices physically separated from each other. The program code or the code segment may represent any combination of procedures, functions, subprograms, routines, subroutines, modules, software packages, classes, or commands, data structures, or program statements. The program code or the code segment may be connected to another code segment or a hardware circuit by transmitting and receiving information, data, an argument, a parameter, or a content of a memory.

Example of Application to Program and Program Product

The image processing method in the embodiments of the present disclosure may be configured as a program or a program product for causing a processor or a computer including the processor to implement functions of each step. The program product is a computer-readable medium that is a tangible, non-transitory information storage medium on which a program is recorded.

A program for causing a computer to achieve some or all of processing functions of the image processing apparatus 220 according to the embodiments of the present disclosure can be recorded on a computer-readable medium that is an optical disk, a magnetic disk, a semiconductor memory, or another tangible, non-transitory storage medium, and the program can be provided through the storage medium.

Alternatively to the aspect of providing the program stored on such a tangible, non-transitory computer-readable medium, the program signal may be provided as a download service via a communication network such as the Internet.

Further, some or all of the processing functions in the image processing apparatus 220 may be achieved by cloud computing, or can be provided as software as a service (SaaS).

Others

The configurations described in each of the above-described embodiments and the features described in the modification examples may be used in appropriate combinations, and some features may be substituted. The present disclosure is not limited to the above-described embodiments, and various modifications can be made without departing from the scope of the invention as defined by the claims.

Explanation of References

10: MRI apparatus
100: measurement unit
102: subject
103: bed
104: static field magnet
106: gradient coil

108: RF coil
110: receive coil
112: radio frequency magnetic field generator
114: gradient magnetic field power supply
116: receiver
118: sequencer
200: control device
202: processor
204: memory
205: storage
206: input/output interface
208: display
210: operation unit
220: image processing apparatus
222: measurement data acquisition unit
223: zero-filling unit
224: reconstruction unit
226: CNN estimation unit
227: filter unit
228: phase image generation unit
230: absolute value image generation unit
232: phase correction unit
234: filter unit
236: Fourier transform unit
238: data replacement unit
240: convergence determination unit
244: reconstruction unit
246: absolute value image generation unit
250: image output unit
252: display controller
254: recording controller
256: image storage unit
270: filter storage unit
272: filter setting unit
280: user interface
282: SNR calculation unit
284: unmeasured proportion setting unit
286: pulse sequence setting unit
320: measurement controller
330: image calculation unit
332: k-space data generation unit
334: inverse Fourier transform unit
337: edge enhancement filter unit
338: Fourier transform unit
340: combination unit
in1: input layer
Conv1 to 9: convolutional layer
Relu1 to 8: activation layer
add1: addition layer
FKt: full measurement data
Fmt: full measurement image
PKt: partial measurement data
Pmt: partial measurement image
Pmu: partial measurement image
PPmu: estimation image
F2A: full measurement data
F2B: image
F4A: k-space

F4B: k-space
F4C: k-space
F4D: k-space
F7A: complex image
F7B: complex image
F8A: image generation process
F8B: image generation process
F8C: image generation process
F8D: image generation process
F10A: k-space data
F10B: k-space data
F11A: image
F11B: image
F17A: MR image
F17B: MR image
F19A: CNN estimation image
F19B: k-space data
F19C: edge enhancement estimation image
F19D: k-space data
F19E: k-space data
F19F: estimation image
F21A: MR image
F21B: MR image
MA: measurement region
UA: unmeasured region
EF1, EF2, EF3: edge enhancement filter
SF1, SF2, SF3: smoothing filter
f1, f2: Hanning window function
S11 to S28: step of image processing method according to first embodiment
S51 to S59: step of image processing method according to second embodiment
S61 to S72: step of image processing method according to third embodiment

**Claims**

1. A magnetic resonance imaging apparatus (10) comprising:

   a processor (202) configured to execute processing of estimating, using a projection onto convex sets method, data of an unmeasured region (UA) from partial measurement data that is data acquired within an asymmetrical measurement region (MA) of a k-space,
   wherein the processor (202) is configured to:

   input a partial measurement image reconstructed based on the partial measurement data to a trained model;
   estimate an image reconstructed from full measurement data corresponding to the partial measurement data from the partial measurement image using the trained model to generate an estimation image;
   generate a phase image indicating a phase distribution from the estimation image; and apply the phase image to phase correction in the projection onto convex sets method.

2. The magnetic resonance imaging apparatus (10) according to claim 1,
wherein the processor (202) is configured to generate the partial measurement image from k-space data including the partial measurement data complemented by filling the unmeasured region (UA) with zero data.

3. The magnetic resonance imaging apparatus (10) according to claim 1 or 2,
wherein the processor (202) is configured to generate the phase image by performing processing of smoothing the estimation image.

4. The magnetic resonance imaging apparatus (10) according to claim 3,
wherein the processor (202) is configured to perform the processing of smoothing the estimation image using a filter.

5. The magnetic resonance imaging apparatus (10) according to claim 4,
wherein the processor (202) is configured to calculate a signal-to-noise ratio of an image generated using the projection onto convex sets method based on the partial measurement data, and set the strength of the filter in accordance with the signal-to-noise ratio.

6. The magnetic resonance imaging apparatus (10) according to claim 4,

   wherein the processor (202) is configured to set the strength of the filter in accordance with an unmeasured proportion of the partial measurement data, and/or
   set the strength of the filter in accordance with a pulse sequence by which the partial measurement data is obtained.

7. The magnetic resonance imaging apparatus (10) according to claim 1,

   wherein an algorithm of the projection onto convex sets method executed by the processor (202) includes:

      processing of generating k-space data including the partial measurement data by filling the unmeasured region (UA) of the partial measurement data with zero data or estimation data;
      processing of generating an absolute value image by performing processing of image reconstruction including an inverse Fourier transform and processing of absolute value image generation on the k-space data;
processing of performing the phase correction by applying the phase image to the absolute value image; and
processing of updating the k-space data by replacing data corresponding to the measurement region (MA) in estimated k-space data generated by a Fourier transform based on the corrected image obtained by the phase correction with the partial measurement data that has been measured or data corresponding to the measurement region (MA) in k-space data generated by a Fourier transform based on the estimation image, and

      the data of the unmeasured region (UA) is estimated by performing iterative processing including generation of the absolute value image, the phase correction, and update of the k-space data.

8. The magnetic resonance imaging apparatus (10) according to claim 1,

   wherein the trained model includes a machine learning model trained through machine learning to receive an input of the partial measurement image and output the estimation image in which a reconstruction image of the full measurement data is estimated,
   or
   the trained model includes a machine learning model trained through machine learning to receive an input of the partial measurement image and output a residual image indicating a difference between the estimation image and the partial measurement image.

9. The magnetic resonance imaging apparatus (10) according to any one of claims 1 to 8,

   wherein the trained model includes a machine learning model generated by performing machine learning using a training dataset including a pair of a first full measurement image reconstructed based on first k-space data in which an entire region of a data acquisition matrix of a k-space is filled with measured data and a first partial measurement image reconstructed based on second k-space data in which an asymmetrical first region of a portion of the data acquisition matrix is filled with measurement data corresponding to the first k-space data and a second region other than the first region is filled with zero data, the first full measurement image being ground-truth data for an input of the first partial measurement image, and

preferably, the second k-space data is generated by replacing data of the second region in the first k-space data with zero data.

10. The magnetic resonance imaging apparatus (10) according to any one of claims 1 to 9, wherein the processor (202) is configured to:

acquire first measurement region data of the measurement region (MA) in k-space data obtained by performing a Fourier transform on the estimation image;

generate a first edge enhancement estimation image by performing edge enhancement filter processing on the estimation image;

acquire first unmeasured region data of the unmeasured region (UA) in k-space data obtained by performing a Fourier transform on the first edge enhancement estimation image;

reconstruct an image based on k-space data including the first measurement region data and the first unmeasured region data to generate a second edge enhancement estimation image; and

generate the phase image from the second edge enhancement estimation image.

11. The magnetic resonance imaging apparatus (10) according to claim 10, wherein the processor (202) is configured to:

acquire first adjacent region data corresponding to an adjacent region that is adjacent to the measurement region (MA) and that extends a predetermined distance from the measurement region (MA), in second unmeasured region data of the unmeasured region (UA) in the k-space data obtained by performing a Fourier transform on the estimation image;

acquire second adjacent region data corresponding to the adjacent region in the first unmeasured region data;

generate third adjacent region data by combining the first adjacent region data and the second adjacent region data while gradually decreasing a weight of the first adjacent region data and gradually increasing a weight of the second adjacent region data as a distance from the measurement region (MA) increases; and

generate the second edge enhancement estimation image by reconstructing an image from k-space data including the first measurement region data, the third adjacent region data, and the first unmeasured region data other than the adjacent region.

12. The magnetic resonance imaging apparatus (10) according to claim 11,

wherein the processor (202) is configured to:

multiply the first adjacent region data by a first window function having a value of 1 at a position adjacent to the measurement region (MA) and a value of 0 at a position at the predetermined distance from the measurement region (MA);

multiply the second adjacent region data by a second window function having a value of 0 at a position adjacent to the measurement region (MA) and a value of 1 at a position at the predetermined distance from the measurement region (MA); and

generate the third adjacent region data by adding the first adjacent region data multiplied by the first window function and the second adjacent region data multiplied by the second window function, and

preferably, the first window function and the second window function are each a Hanning window.

13. The magnetic resonance imaging apparatus (10) according to any one of claims 10 to 12, wherein the processor (202) is configured to:

acquire filter strength of the edge enhancement filter processing; and

generate the first edge enhancement estimation image on which the edge enhancement filter processing is performed with the acquired filter strength.

14. An image processing method executed by a processor (202), the image processing method comprising:

acquiring partial measurement data that is data acquired within an asymmetrical measurement region (MA) of a k-space;

inputting a partial measurement image reconstructed based on the partial measurement data to a trained model;

estimating an image reconstructed from full measurement data corresponding to the partial measurement data from the partial measurement image using the trained model to generate an estimation image;

generating a phase image indicating a phase distribution from the estimation image;

applying the phase image to phase correction in the projection onto convex sets method; and

executing processing of estimating data of an unmeasured region (UA) other than the measurement region (MA) in the k-space using the projection onto convex sets method.

15. A non-transitory computer-readable recording medium on which a program for causing a computer to execute the image processing method according to claim 14 is recorded.

FIG. 1

10

**MEASUREMENT UNIT** — 100

- STATIC FIELD MAGNET — 104
- 106
- 108
- 110
- 102
- 103
- 108
- 106
- 104

- GRADIENT MAGNETIC FIELD POWER SUPPLY — 114
- RADIO FREQUENCY MAGNETIC FIELD GENERATOR — 116
- RECEIVER — 112
- SEQUENCER — 118

**CONTROL DEVICE** — 200

- INPUT/OUTPUT INTERFACE — 206
- DISPLAY — 208
- OPERATION UNIT — 210
- PROCESSOR — 202
- MEMORY — 204
- STORAGE — 205

# FIG. 2

(FULL MEASUREMENT DATA)

F2A

IMAGE
RECONSTRUCTION

F2B

(MR IMAGE)

# FIG. 3

# FIG. 4

F4A

MEASUREMENT REGION | UNMEASURED REGION

ky

kx

F4B

UNMEASURED REGION | MEASUREMENT REGION

F4C

UNMEASURED REGION

MEASUREMENT REGION

F4D

MEASUREMENT REGION

UNMEASURED REGION

# FIG. 5

FULL MEASUREMENT DATA

PARTIAL MEASUREMENT DATA

UNMEASURED REGION

INPUT IMAGE (PARTIAL MEASUREMENT DATA)

FKt

PKt

Pmu

IMAGE RECONSTRUCTION

CNN ESTIMATION

Fmt

Pmt

PPmu

y

x

TRAINING USING FULL MEASUREMENT DATA AS GROUND TRUTH

ESTIMATION RESULT

EP 4 782 867 A1

# FIG. 6

2ch INPUT

in1

conv1

relu1

conv2

relu2

conv3

relu3

conv4

relu4

NINE-LAYER CNN (Conv+Relu)

conv5

relu5

conv6

relu6

conv7

relu7

conv8

relu8

conv9

add1

reg

2ch OUTPUT

# FIG. 7

COMPLEX IMAGE AS INPUT

F7A

REAL PART      IMAGINARY PART

COMPLEX IMAGE AS OUTPUT

F7B

REAL PART      IMAGINARY PART

FIG. 8

# FIG. 9

Zero Matrix

Initial partial k-space
data set $M_{pk}(k_x,k_y)$

Replace Data

Data Constrained
k-Space Data
$M_i(k_x,k_y)$

Replace Data

$DFT^{-1}$

Symmetric
Data

$m_i(x,y)$

$DFT^{-1}$

abs $(m_i(x,y))$

$m_s(x,y)$

$p(x,y) =$
$exp(i\ arg\ \{m_s(x,y)\})$

X

$p(x,y)abs(m_i(x,y))$

Phase Constrained
Image Data

$DFT$

# FIG. 10

MEASUREMENT DATA (ESTIMATION RESULT)

NOISE IS NOT ESTIMATED

MEASUREMENT REGION | UNMEASURED REGION | MEASUREMENT REGION | UNMEASURED REGION

F10A

POCS METHOD

ESTIMATION REGION

F10B

CNN ESTIMATION

ESTIMATION REGION

EP 4 782 867 A1

FIG. 11

RECONSTRUCTION IMAGE

NOISE APPEARS IN STRIPE SHAPE IN HORIZONTAL DIRECTION

F11B

CNN ESTIMATION

F11A

POCS METHOD

FIG. 12

IMAGE RECONSTRUCTION & ABSOLUTE VALUE IMAGE GENERATION

m(x,y) — OUTPUT IMAGE

CONVERGENCE? — No / Yes

REPLACEMENT WITH MEASURED DATA

PPKj(kx,ky) — MEASUREMENT DATA ESTIMATION RESULT

SMOOTHING FILTER, EDGE ENHANCEMENT FILTER

FFT

ABj(x,y) — ABSOLUTE VALUE IMAGE

IMAGE RECONSTRUCTION

ABSOLUTE VALUE IMAGE GENERATION

PK(kx,ky)

MA / UA

UNMEASURED REGION

INPUT DATA (COMPLEX)

Pm(x,y)

IMAGE RECONSTRUCTION

RECONSTRUCTION IMAGE (COMPLEX)

CNN ESTIMATION

Cm(x,y) — CNN ESTIMATION IMAGE (COMPLEX)

PHASE CORRECTION

SMOOTHING FILTER

CFm(x,y)

$$\tan^{-1}\left(\frac{\text{IMAGINARY PART}}{\text{REAL PART}}\right)$$

Cp(x,y) — PHASE IMAGE

# FIG. 13

PARTIAL k-SPACE DATA

PKze(kx,ky)

MA — MEASURED DATA

UA — UNMEASURED REGION

k-SPACE DATA ESTIMATION RESULT

PPKj(kx,ky) — MEASUREMENT REGION

ESTIMATION REGION — PA

220

222 — MEASUREMENT DATA ACQUISITION UNIT

223 — ZERO-FILLING UNIT

224 — RECONSTRUCTION UNIT FFT-1

230 — ABSOLUTE VALUE IMAGE GENERATION UNIT

ABj(x,y) — ABSOLUTE VALUE IMAGE

238 — DATA REPLACEMENT UNIT

240 — CONVERGENCE DETERMINATION UNIT

244 — RECONSTRUCTION UNIT

246 — ABSOLUTE VALUE IMAGE GENERATION UNIT

232 — PHASE CORRECTION UNIT

234 — FILTER UNIT

236 — FFT

Pm(x,y) — RECONSTRUCTION IMAGE (COMPLEX)

226 — CNN ESTIMATION UNIT

227 — FILTER UNIT

228 — PHASE IMAGE GENERATION UNIT

Cp(x,y) — PHASE IMAGE

ESTIMATION IMAGE — Cm(x,y)

250 — IMAGE OUTPUT UNIT

252 — DISPLAY CONTROLLER

256 — IMAGE STORAGE UNIT

208 — DISPLAY

EP 4 782 867 A1

# FIG. 14

```
                              ( START )
                                 │
                                 ▼
          ┌──────────────────────────────────────────┐
          │     ACQUIRE PARTIAL MEASUREMENT DATA      │──S11
          └──────────────────────────────────────────┘
                                 │
                                 ▼
          ┌──────────────────────────────────────────┐
          │       FILL UNMEASURED REGION WITH ZERO    │──S12
          └──────────────────────────────────────────┘
                                 │
                                 ▼
          ┌──────────────────────────────────────────┐
          │            IMAGE RECONSTRUCTION           │──S13
          └──────────────────────────────────────────┘
```

Pm(x,y) — RECONSTRUCTION IMAGE (COMPLEX)

S14 — CNN ESTIMATION

Cm(x,y) — ESTIMATION IMAGE (COMPLEX)

S15 — SMOOTHING FILTER PROCESSING

S16 — GENERATE PHASE IMAGE $\tan^{-1}$(IMAGINARY PART / REAL PART)

Cp(x,y) — PHASE IMAGE

GENERATE ABSOLUTE VALUE IMAGE — S20

ABj(x,y) — ABSOLUTE VALUE IMAGE

PHASE CORRECTION — S21

SMOOTHING FILTER PROCESSING — S22

FOURIER TRANSFORM — S23

MEASUREMENT DATA ESTIMATION RESULT

MEASUREMENT DATA ESTIMATION RESULT — S24

REPLACE MEASUREMENT REGION WITH MEASURED DATA — S25

GENERATE ABSOLUTE VALUE IMAGE — S26

CONVERGENCE? — S27   NO

YES

STORE IMAGE — S28

( END )

# FIG. 15

Data consistency (REPLACEMENT WITH MEASUREMENT REGION DATA)

ABSOLUTE VALUE IMAGE GENERATION

PCK(kx,ky)

MA — MEASUREMENT REGION

PA — ESTIMATION RESULT

k-SPACE DATA

ABj(x,y)

ABSOLUTE VALUE IMAGE

FFT

PPKj(kx,ky)

PA

ESTIMATED k-SPACE DATA

INVERSE FFT

DCmj(x,y)

IMAGE AFTER Data consistency

CONVERGENCE?  No / Yes

FFT

ABSOLUTE VALUE IMAGE GENERATION

MULTIPLY BY exp(iθ)

Pm(x,y)

PARTIAL MEASUREMENT IMAGE (COMPLEX)

CNN ESTIMATION

Cm(x,y)

CNN ESTIMATION IMAGE (COMPLEX)

GAUSSIAN FILTER

CFm(x,y)

SMOOTHED IMAGE (COMPLEX)

PHASE CALCULATION

PHASE IMAGE θ

m(x,y)

OUTPUT IMAGE

EP 4 782 867 A1

## FIG. 16

## FIG. 17

F17A — NOISE APPEARS IN STRIPE SHAPE IN HORIZONTAL DIRECTION

F17B — SUPPRESS STRIPED NOISE IN HORIZONTAL DIRECTION

CNN ESTIMATION

POCS METHOD + CNN ESTIMATION PHASE

EP 4 782 867 A1

FIG. 18

DEGRADATION IN RESOLUTION

F18B — CNN ESTIMATION

F18A — POCS METHOD

FIG. 19

F19A
CNN ESTIMATION IMAGE

FFT

F19B
DATA A

WITHOUT FILTER

F19E

INVERSE FFT

F19F
ONLY UNMEASURED REGION IS EDGE-ENHANCED

WITH FILTER

F19C
CNN ESTIMATION IMAGE + EDGE ENHANCEMENT FILTER

FFT

F19D
DATA B

# FIG. 20

START

ACQUIRE PARTIAL MEASUREMENT DATA — S51

ACQUIRE CNN ESTIMATION IMAGE — S52

CONVERT CNN ESTIMATION
IMAGE INTO K-SPACE DATA — S53

ACQUIRE DATA A
OF MEASUREMENT REGION — S54

ACQUIRE EDGE ENHANCEMENT
ESTIMATION IMAGE — S55

ACQUIRE k-SPACE DATA OF EDGE
ENHANCEMENT ESTIMATION IMAGE — S56

ACQUIRE DATA B
OF UNMEASURED REGION — S57

ACQUIRE K-SPACE DATA IN WHICH
DATA A AND DATA B ARE COMBINED — S58

ACQUIRE OUTPUT IMAGE IN WHICH
ONLY UNMEASURED REGION
IS EDGE-ENHANCED — S59

END

# FIG. 21

F21A

F21B

IMPROVEMENT IN RESOLUTION

CNN ESTIMATION METHOD

CNN ESTIMATION METHOD + ONLY
UNMEASURED REGION IS EDGE-ENHANCED

# FIG. 22

FIG. 23

FIG. 24

# FIG. 25

START

ACQUIRE PARTIAL MEASUREMENT DATA — S61

ACQUIRE CNN ESTIMATION IMAGE — S62

CONVERT CNN ESTIMATION IMAGE INTO DATA A0 OF k-SPACE — S63

ACQUIRE DATA A1 OF MEASUREMENT REGION AND DATA A1 OF ADJACENT REGION FROM DATA A0 — S64

GENERATE DATA A3 FROM DATA A2 USING WINDOW FUNCTION f1 — S65

ACQUIRE EDGE ENHANCEMENT ESTIMATION IMAGE — S66

CONVERT EDGE ENHANCEMENT ESTIMATION IMAGE INTO DATA B0 OF k-SPACE — S67

ACQUIRE DATA B1 OF REGION EXCLUDING ADJACENT REGION IN UNMEASURED REGION AND DATA B2 OF ADJACENT REGION FROM DATA B0 — S68

GENERATE B3 FROM DATA B3 USING WINDOW FUNCTION f2 — S69

GENERATE DATA C1 FROM DATA A3 AND DATA B3 — S70

COMBINE DATA A1, DATA C1, AND DATA B1 — S71

ACQUIRE OUTPUT IMAGE IN WHICH UNMEASURED REGION IS EDGE-ENHANCED AND BOUNDARIES ARE SMOOTHLY CONNECTED — S72

END

Europäisches
Patentamt
European
Patent Office
Office européen
des brevets

# EUROPEAN SEARCH REPORT

**Application Number**

EP 26 15 4850

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | HAACKE, E.M. ET AL: "A fast, iterative, partial-fourier technique capable of local phase recovery", JOURNAL OF MAGNETIC RESONANCE. ACADEMIC PRESS, LONDON., GB, vol. 92, no. 1, 1 March 1991 (1991-03-01), pages 126-145, XP023961320, ISSN: 0022-2364, DOI: 10.1016/0022-2364(91)90253-P [retrieved on 1991-03-01] * the whole document * ----- | 1-15 | INV. G01R33/48 G01R33/56 G01R33/561 G01R33/565 |
| A,D | US 2022/198725 A1 (LITWILLER DANIEL VANCE [US] ET AL) 23 June 2022 (2022-06-23) * paragraph [0036] - paragraph [0043]; figure 2 * ----- | 1-15 | |

TECHNICAL FIELDS
SEARCHED    (IPC)

G01R

The present search report has been drawn up for all claims

| Place of search | Date of completion of the search | Examiner |
|---|---|---|
| Munich | 8 June 2026 | Raguin, Guy |

EPO FORM 1503 03.82 (P04C01)

## ANNEX TO THE EUROPEAN SEARCH REPORT
## ON EUROPEAN PATENT APPLICATION NO.

EP 26 15 4850

This annex lists the patent family members relating to the patent documents cited in the above-mentioned European search report.
The members are as contained in the European Patent Office EDP file on
The European Patent Office is in no way liable for these particulars which are merely given for the purpose of information.

08-06-2026

| Patent document cited in search report | Publication date | Patent family member(s) | | Publication date |
|---|---|---|---|---|
| US 2022198725 A1 | 23-06-2022 | CN | 114663537 A | 24-06-2022 |
| | | EP | 4019996 A1 | 29-06-2022 |
| | | US | 2022198725 A1 | 23-06-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20220198725 A

**Non-patent literature cited in the description**

- **E.M HAACKE** ; **E.D LINDSKOG** ; **W LIN**. A fast, iterative, partial-fourier technique capable of local phase recovery. *Journal of Magnetic Resonance*, 1991, vol. 92 (1), https://users.fmrib.ox.ac.uk/~karla/reading_group/lecture_notes/Recon_Pauly_read.pdf